# EUROPÄISCHE PATENTSCHRIFT

(11) **EP 0 925 319 B1**
(45) Veröffentlichungstag und Bekanntmachung des Hinweises auf die Patenterteilung: **05.12.2001**
(21) Anmeldenummer: 97943830.6
(22) Anmeldetag: 04.09.1997
(51) Int. Cl.: C08G 73/06, C08G 73/10, C09K 11/06

(54) **TRIAZINPOLYMERE UND DEREN VERWENDUNG IN ELEKTROLUMINESZIERENDEN ANORDNUNGEN**
TRIAZINE POLYMERS AND THE APPLICATION THEREOF IN ELECTROLUMINESCENT ARRANGEMENTS
POLYMERES DE TRIAZINE ET LEUR UTILISATION DANS DES DISPOSITIFS ELECTROLUMINESCENTS

(30) Priorität: 16.09.1996 DE 19637600; 29.10.1996 DE 19644930
(43) Veröffentlichungstag der Anmeldung: 30.06.1999
(73) Patentinhaber: BAYER AG, 51368 Leverkusen (DE)
(72) Erfinder: WEHRMANN, Rolf, D-47800 Krefeld (DE); SCHMIDT, Hans-Werner, D-95444 Bayreuth (DE); FINK, Ralph, D-95444 Bayreuth (DE); THELAKKAT, Mukundan, D-95448 Bayreuth (DE)
(86) Internationale Anmeldenummer: EP9704802
(87) Internationale Veröffentlichungsnummer: WO9811150

(56) Entgegenhaltungen:
- EP-A- 0 129 036
- EP-A- 0 668 529
- US-A- 3 803 075
- US-A- 4 102 872
- FINK ET AL: "Aromatic polyethers with 1,3,5-triazine units as hole blocking/electron transport materials in LEDs" PAPERS PRESENTED AT THE SAN FRANCISCO, CALIFORNIA MEETING, DIVISION OF POLYMER CHEMISTRY, INC., AMERICAN CHEMICAL SOCIETY, Bd. 38, Nr. 1, 1.April 1997, Seiten 323-324, XP002049555

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-P 4 539 507, US-P 4 769 262, US-P 5 077 142, EP-A 406 762). Auch mit diesen Materialien können - bedingt durch das Herstellverfahren - nur kleindimensionierte LEDs hergestellt werden.

Weiterhin werden Polymere, wie Poly-(p-phenylene) und Poly-(p-phenylenvinylene (PPV)) als elektrolumineszierende Polymere beschrieben: G. Leising et al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 443 861, WO-A-9203490 und 92003491 beschrieben.

EP-A 0 294 061 stellt einen optischen Modulator auf Basis von Polyacetylen vor.

Zur Herstellung flexibler Polymer-LEDs haben Heeger at al. lösliche konjugierte PPV-Derivate vorgeschlagen (WO 92/16023).

Polymerblends unterschiedlicher Zusammensetzung sind ebenfalls bekannt: M. Stolka et al., Pure & Appt. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
- 1: Träger, Substrat
- 2: Basiselektrode
- 3: Löcher-injizierende Schicht
- 4: Löcher-transportierende Schicht
- 5: Licht-emittierende Schicht
- 6: Elektronen-transportierende Schicht
- 7: Elektronen-injizierende Schicht
- 8: Topelektrode
- 9: Kontakte
- 10: Umhüllung, Verkapselung.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO 90/13148 auf der Basis von Poly-(p-phenylenvinylen) beschrieben.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings stellt der Anlöseprozeß einer bereits aufgebrachten Schicht beim Überschichten mit der nächsten Schicht eine Schwierigkeit dar.

Die Aufgabe der vorliegenden Erfindung ist die Bereitstellung von elektrolumineszierenden Anordnungen mit hoher Leuchtdichte, wobei die aufzubringende Mischung gießbar aufgebracht werden kann.

Die Erfindung betrifft daher Polymere mit 1,3,5-Triazineinheiten - im folgenden Triazine genannt - und deren Verwendung in elektrolumineszierenden Anordnungen als Schicht, z.B. Elektroneninjektionsschicht, elektronenleitende oder lumineszierende Schicht. Polymere diesen Typs weisen gute Reduktionseigenschaften, bei hoher Oxidationsstabilität auf. Zudem sind sie sehr gut filmbildend, besitzen hohe Glasstufen und sind hoch temperaturstabil. Die Verarbeitung erfolgt bevorzugt aus Alkoholen, Ketonen, Ethern oder N-Methylpyrrolidon.

Polymere mit Triazineinheiten sind bekannt (D. Braun, R. Ghahary, T. Ziser, "Triazine-based polymers", Angew. Makromol. Chem. 233 (1995); M. Strukelj, J.C. Hedrick, "Synthesis and Characterization of Novel Poly(aryl) ether pyridyltriazine)s", Macromolecules 27 (1994)). Bei den beschriebenen Materialien handelt es sich zumeist um Polyamide und Polyimide, bzw. 3,5,6-Triphenyl-1,2,4-triazine, also unsymmetrisch substituierte Systeme.

Sie besitzen zumeist nur geringe Löslichkeiten in - bevorzugt - Alkoholen, Ketonen, Ethern oder N-Methylpyrrolidon (NMP). Weiterhin sind Imide auf Basis von 2,4,6-Triphenyl-triazinen bekannt (Kray, Seltzer, Winter, "S-Triazine based polybenzimidazoles and polyimides", Amer. Chem. Soc., Div. Org. Coatings Plast. Chem., Pap. (1971), 31(1)).

Die vorliegende Erfindung betrifft Polymere und/oder Copolymere mit wiederkehrenden Einheiten der Formel (I) 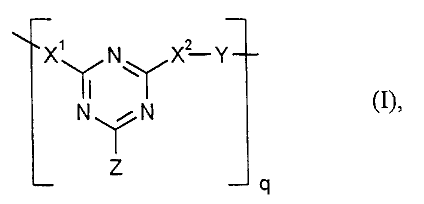 wobei die Reste X¹, X², Y, Z voneinander unabhängig variierbar sind,
- q: für eine ganze Zahl von 3 bis 1 000, vorzugsweise 5 bis 500,
- X¹ und X²: unabhängig voneinander für -O-, -NH-, Phenyl oder eine chemische Bindung stehen und
- Y: für einen 2-bindigen Rest steht, ausgewählt aus 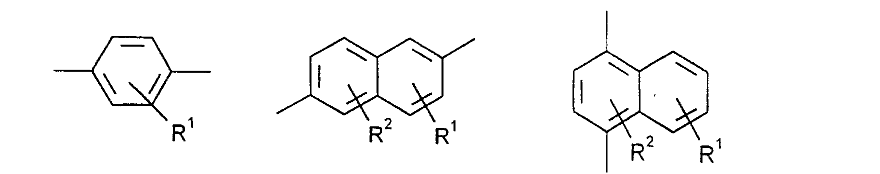 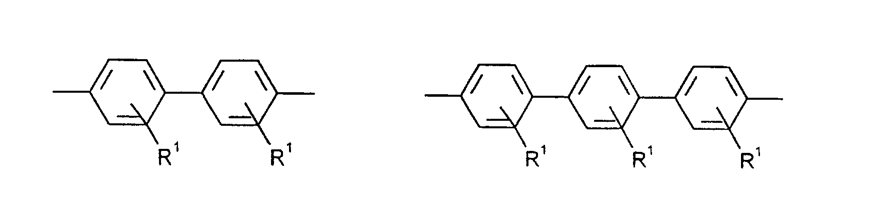 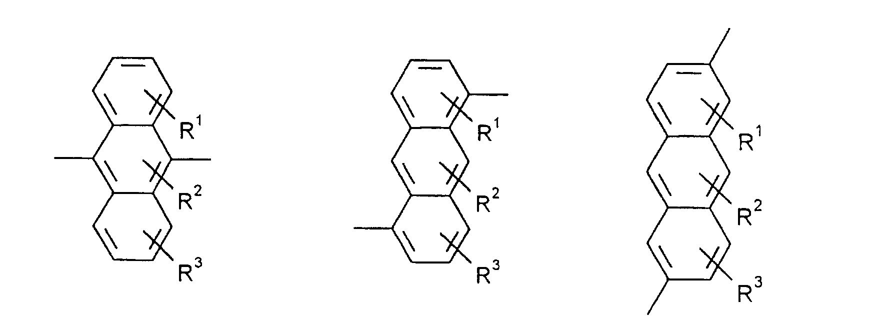 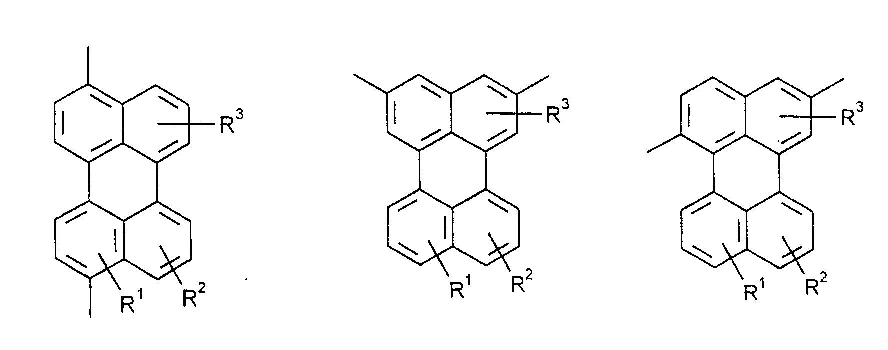 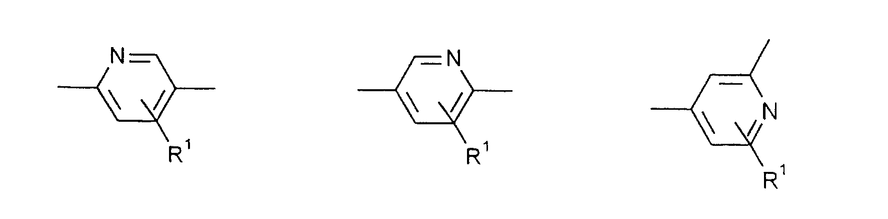 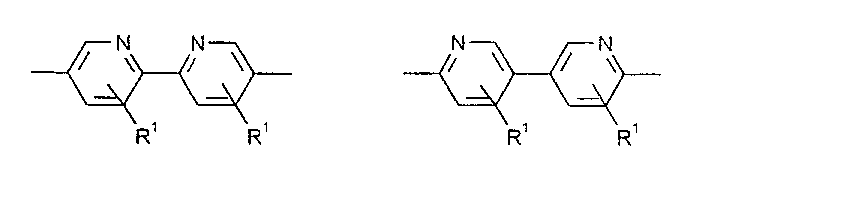 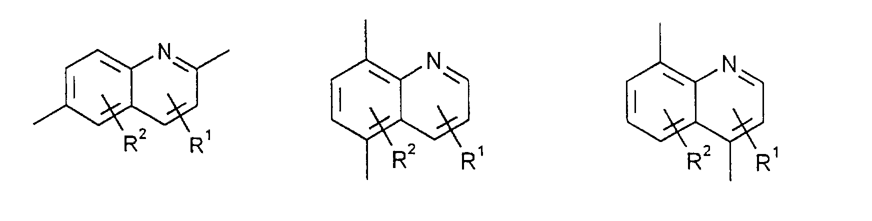 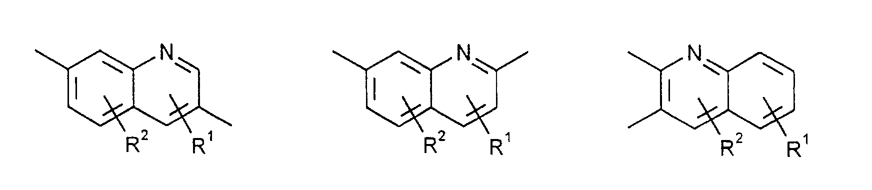 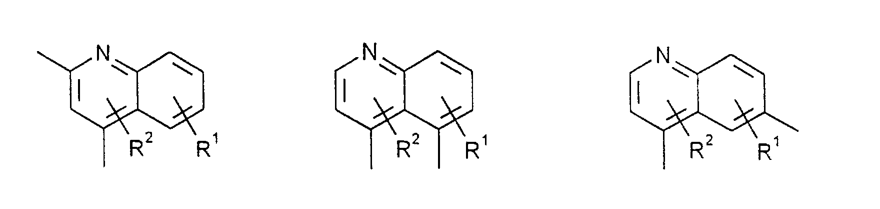 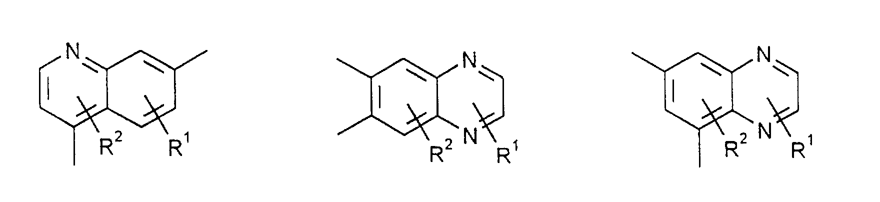 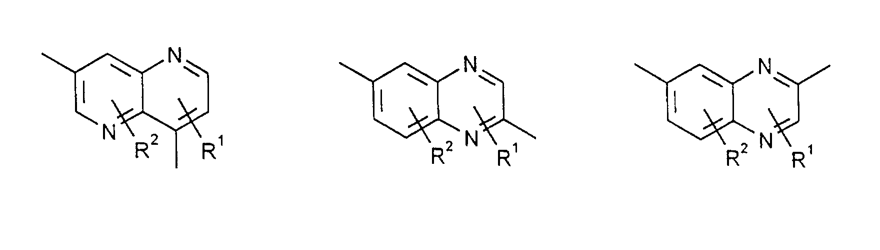 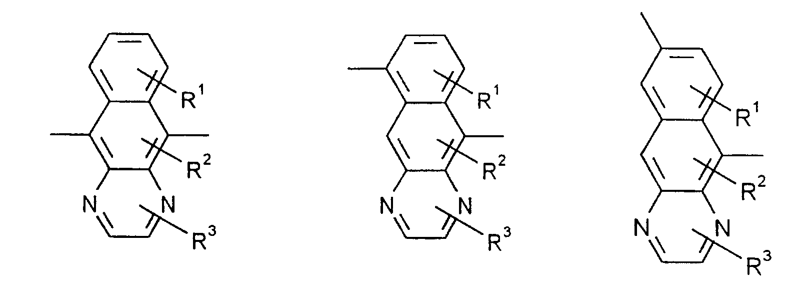 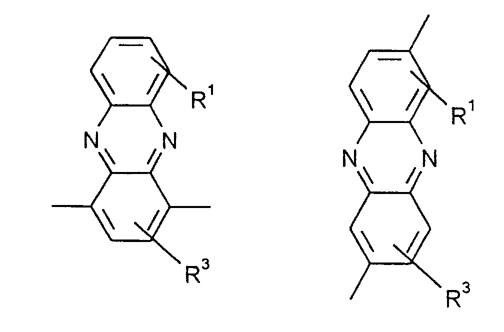 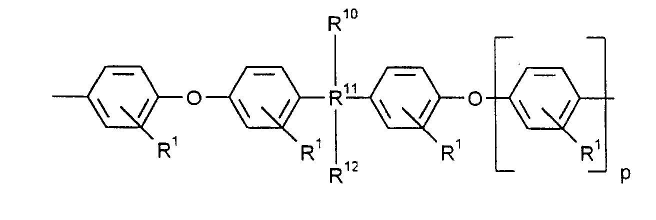 mit p = 0 oder 1 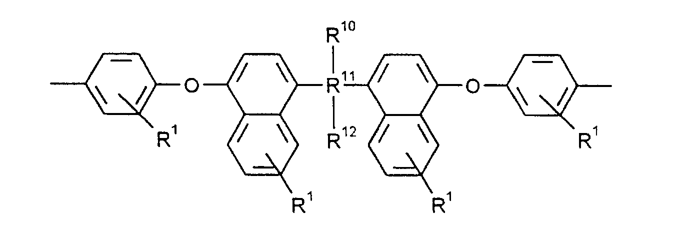 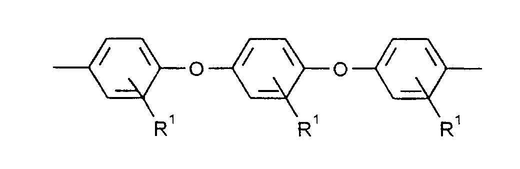 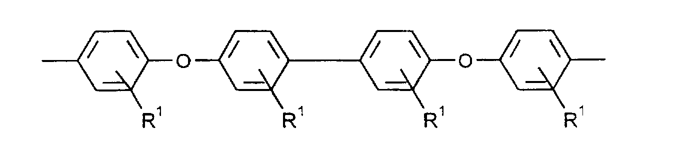 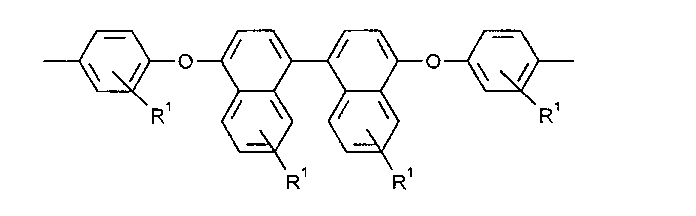 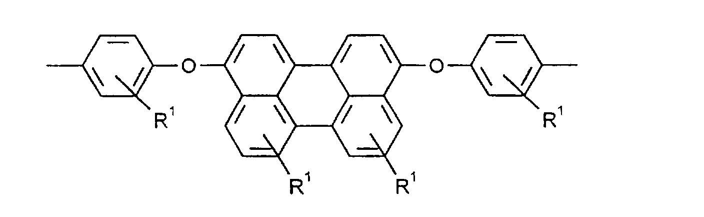 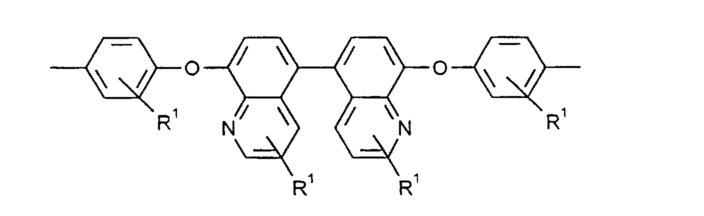 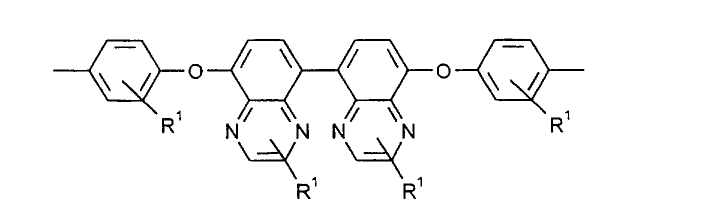 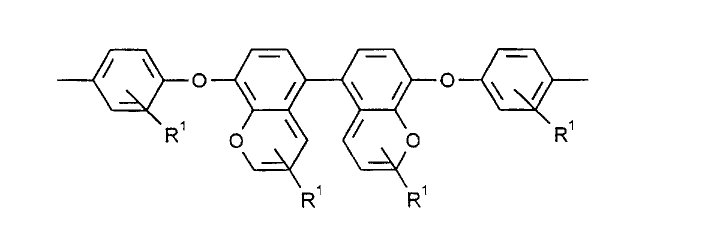 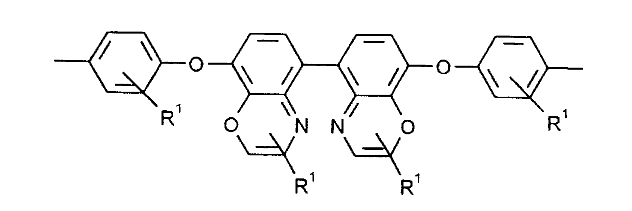 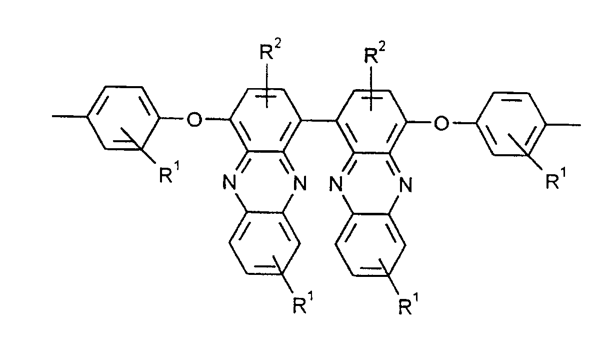 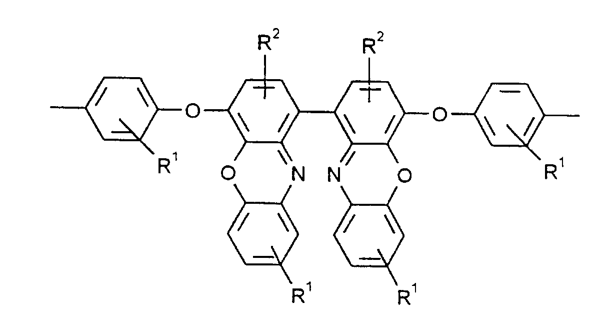 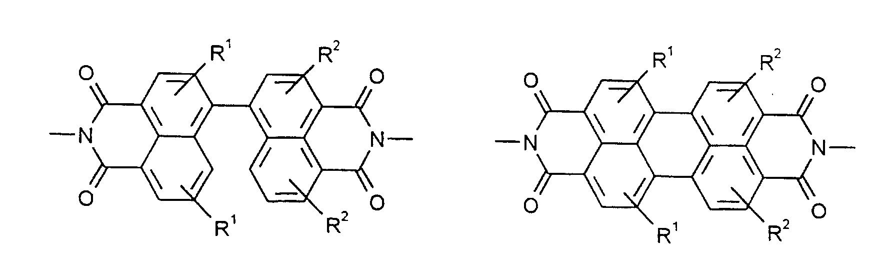 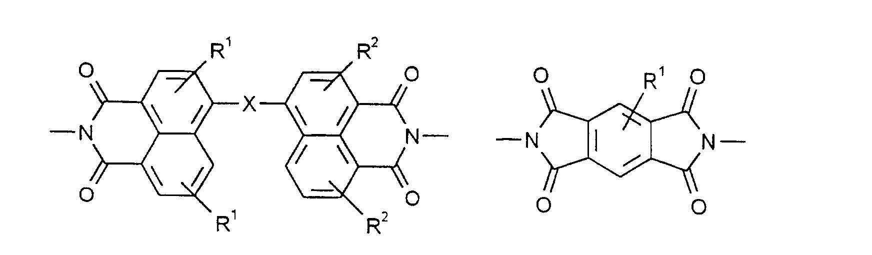 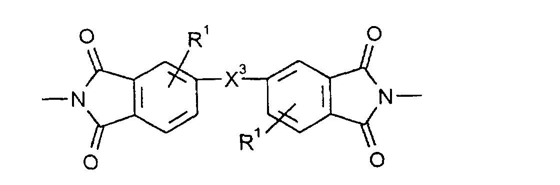
- wobei X³: für 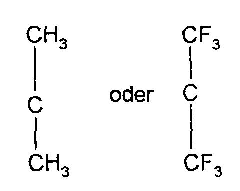 steht, 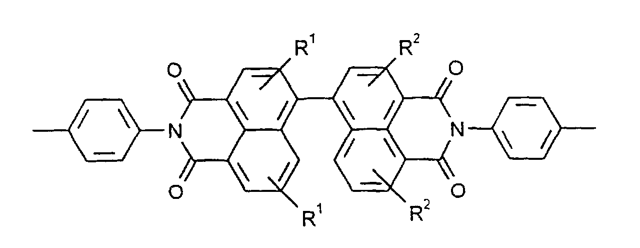 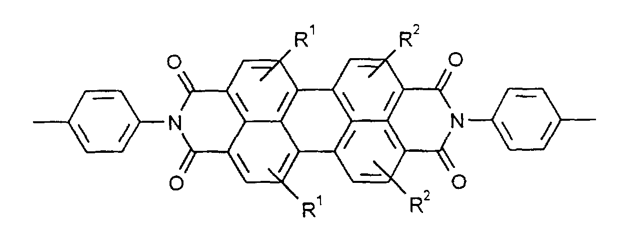 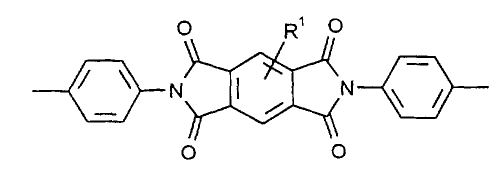
wobei
- R¹, R², R³, R¹⁰ und R¹²: unabhängig voneinander für Wasserstoff, gegebenenfalls substituiertes C₁-C₁₀-Alkyl, C₁-C₁₀-Alkoxy, Alkoxycarbonyl-substituiertes C₁-C₁₀-Alkyl, jeweils gegebenenfalls substituiertes Aryl, Aryl-C₁-C₆-alkyl oder Cycloalkyl stehen,
- R¹¹: für die gleichen Reste wie R¹⁰ oder R¹² mit Ausnahme von Wasserstoff steht, wobei R¹¹ zusätzlich für Sulfonyl oder Sulfoxyl stehen kann, oder
- Y: für einen Rest der Formel (II) steht 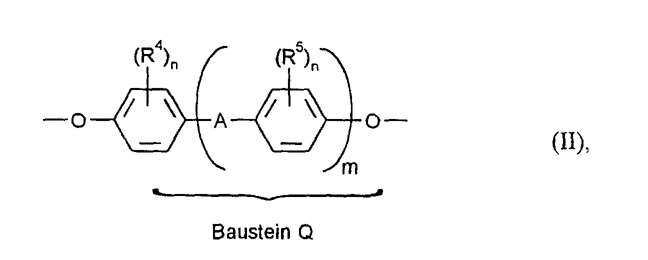
wobei
- R⁴ und R⁵: gleich oder verschieden sind und für Halogen, vorzugsweise Fluor, Chlor und Brom, C₁-C₄-Alkyl, vorzugsweise Methyl und Ethyl, C₆-C₁₂-Aryl, vorzugsweise Phenyl und Biphenyl oder C₇-C₁₂-Aralkyl, vorzugsweise Methylphenyl und Ethylphenyl, stehen,
- n: 0 oder eine ganze Zahl von 1 bis 4, vorzugsweise 0, 1 oder 2 bedeutet,
- A: für eine chemische Bindung, CO, O, S, SO₂ oder einen Rest der Formel (III) oder (IV) 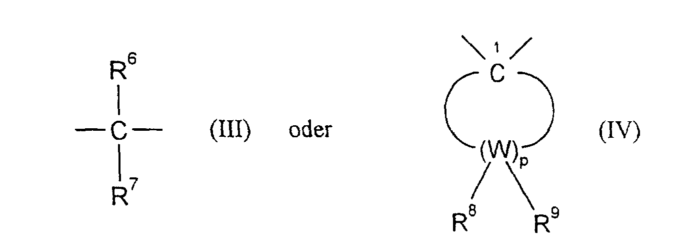 steht, worin
R⁶ und R⁷ gleich oder verschieden sind und für Wasserstoff, Halogen, bevorzugt Fluor, Chlor und Brom, C₁-C₄-Alkyl, bevorzugt Methyl und Ethyl, Halogen-C₁-C₄-alkyl, bevorzugt Trifluormethyl oder C₅-C₁₂-Cycloalkyl mit gegebenenfalls einem oder mehreren Alkylsubstituenten, beispielsweise Cyclohexyl, Methylcyclopentyl und Methylcyclohexyl stehen,
p eine ganze Zahl von 4 bis 7, bevorzugt 4 oder 5 ist,
R⁸ und R⁹ für jedes W individuell wählbar sind und unabhängig voneinander Wasserstoff oder C₁-C₆-Alkyl, bevorzugt Wasserstoff oder Methyl, bedeuten und
W Kohlenstoff bedeutet,
mit der Maßgabe, daß an mindestens einem Atom W die Reste R⁸ und R⁹ gleichzeitig Alkyl sind,
m 0 oder eine ganze Zahl von 1 bis 3, vorzugsweise 0, 1 oder 2, besonders bevorzugt 0 oder 1, bedeutet,
- Z: für Wasserstoff, Halogen, CN, gegebenenfalls durch Halogen substituiertes C₁-C₂₀-Alkyl, C₁-C₁₀-Alkoxycarbonyl substituiertes C₁-C₁₀-Alkyl, jeweils gegebenenfalls durch Halogen, C₁-C₆-Alkyl, Halogen-C₁-C₆-alkyl und/oder C₁-C₆-Alkoxy substituiertes C₆-C₁₀-Aryl, Aryl-C₁-C₆-alkyl, Pyridyl oder Isochinolyl, C₄-C₁₀-Cycloalkyl oder einen Rest der Formel 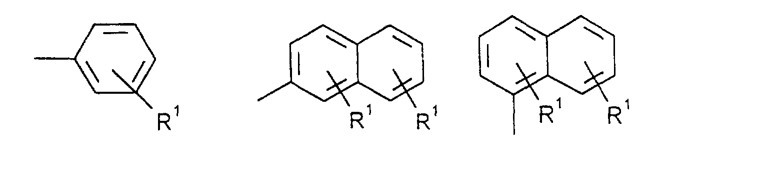 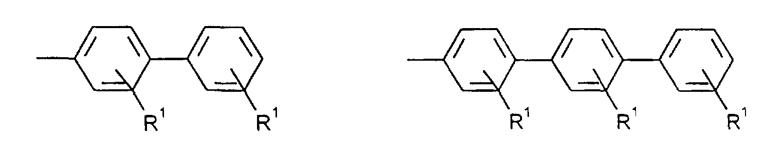 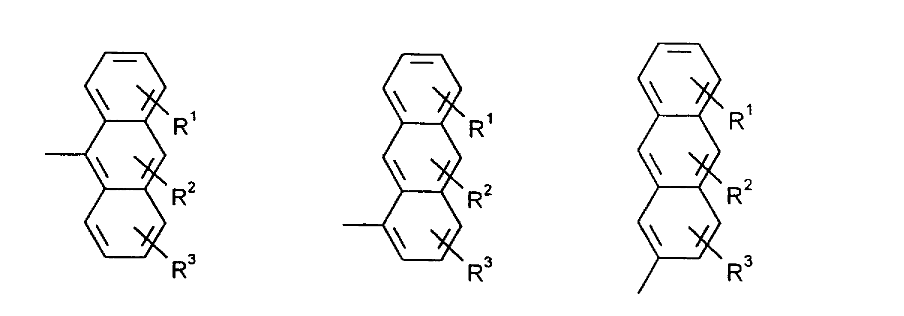 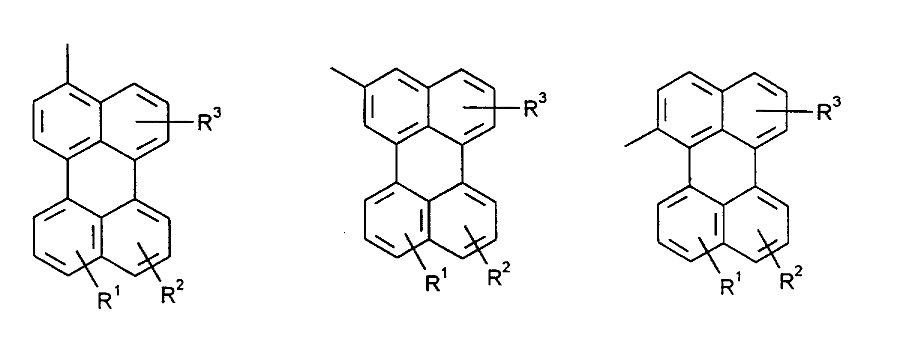 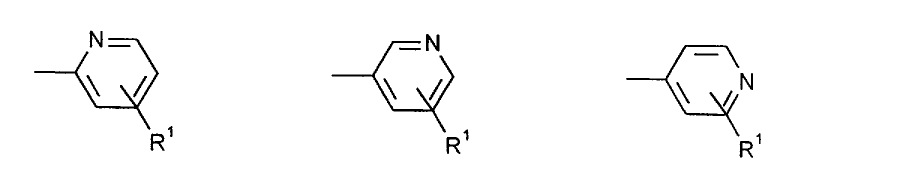 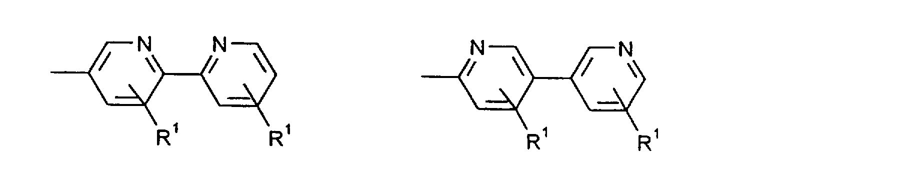 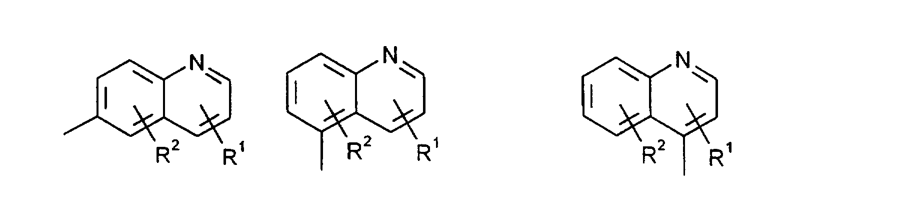 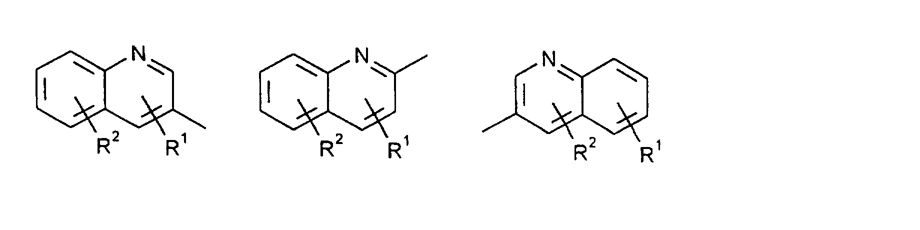 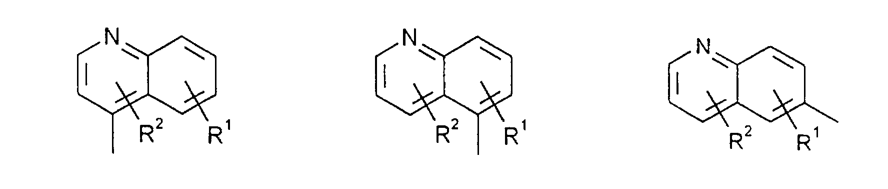 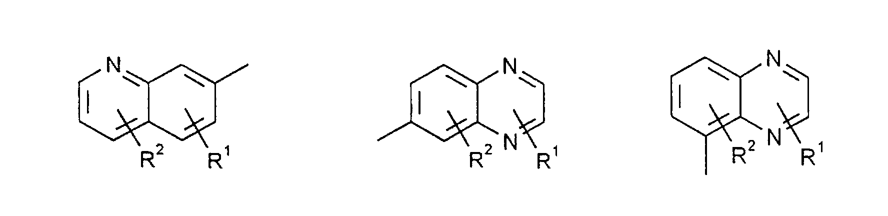 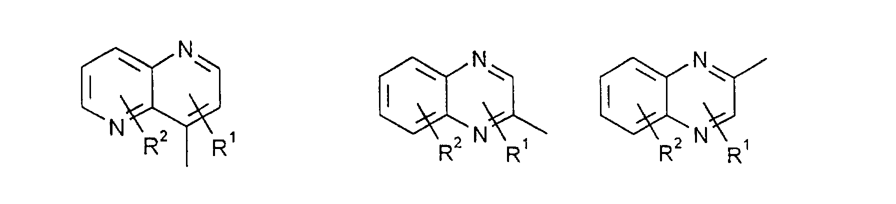 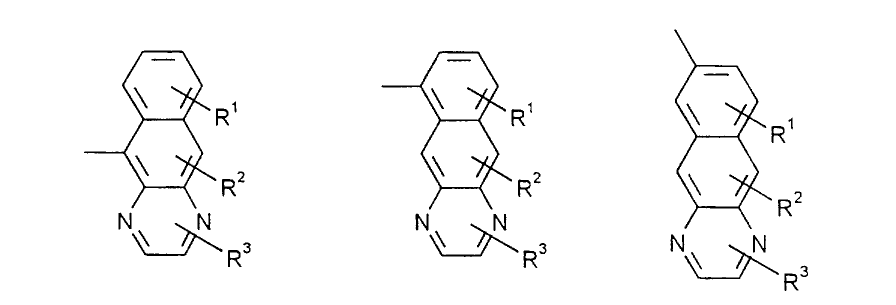 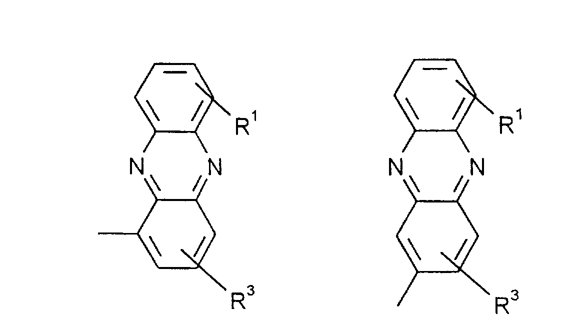 wobei R¹, R² und R³ die oben genannte Bedeutung haben,
steht.

Geeignete Diphenole (Baustein Q) der Formel (II) sind z.B.:
Hydrochinon,
Methylhydrochinon,
Phenylhydrochinon,
Resorcin,
Dihydroxydiphenyle,
Bis-(hydroxyphenyl)-alkane,
Bis-(hydroxyphenyl)-cycloalkane,
Bis-(hydroxyphenyl)-sulfide,
Bis-(hydroxyphenyl)-ether,
Bis-(hydroxyphenyl)-ketone,
Bis-(hydroxyphenyl)-sulfone,
4,4'-Dihydroxybenzophenon,
Hexafluorisopropyliden-diphenol,
3,3,5-Trimethyl-1,1-bis-(4-hydroxyphenyl)-cyclohexan,
3,3,5-Trimethyl-1,1-bis-(4-hydroxy-3,5-dimethylphenyl)-cyclohexan,
3,3,5,5-Tetramethyl-1,1-bis-(4-hydroxyphenyl)-cyclohexan,
3,3,5,5-Tetramethyl-1,1-bis-(4-hydroxy-2,5-dimethylphenyl)-cyclohexan,
3,3,5-Trimethyl-1,1-bis-(4-hydroxyphenyl)-cyclopentan,
3,3,5-Trimethyl-1,1-bis-(4-hydroxy-3,5-dimethylphenyl)-cyclopentan,
Bis-(hydroxyphenyl)-sulfoxide,
a,a'-Bis-(hydroxyphenyl)-diisopropylbenzole
sowie deren C₁-C₆-kernalkylierte und kem(F,Cl,Br)halogenierte Verbindungen.

Diese und weitere geeignete andere Diphenole (Baustein Q) der Formel (II) sind z.B. in den US-A 3 028 365, 2 999 835, 3 148 172, 2 069 560, 3 275 601, 2 991 273, 3 271 367, 3 062 781, 2 970 131, 2 069 573 und 2 999 846, in der DE-A 1 570 703, 2 063 050, 2 063 052, 2 211 095 und 3 832 936, der FR-A 1 561 518, der JP-A 62 093/86, 62 040/86 und 105 550/86 und in der Monographie "H. Schnell, Chemistry and Physics of Polycarbonates, Interscience Publishers, New York 1964", beschrieben.

Bevorzugte andere Diphenole sind beispielsweise:
4,4'-Dihydroxydiphenyl,
2,2-Bis-(4-hydroxyphenyl)-propan,
2,4-Bis-(4-hydroxyphenyl)-2-methylbutan,
1,1-Bis-(4-hydroxyphenyl)-cyclohexan,
a,a'-Bis-(4-hydroxyphenyl)-p-diisopropylbenzol,
2,2-Bis-(3 -methyl-hydroxyphenyl)-propan,
2,2-Bis-(3-chlor-4-hydroxyphenyl)-propan,
Bis-(3,5-dimethyl-4-hydroxyphenyl)-methan,
2,2-Bis-(3,5-dimethyl-4-hydroxyphenyl)-propan,
Bis-(3,5-dimethyl-4-hydroxyphenyl)-sulfon,
2,4-Bis-(3,5-dimethyl-4-hydroxyphenyl)-2-methylbutan,
1,1-Bis-(3,5-dimethyl-4-hydroxyphenyl)-cyclohexan,
a,a'-Bis-(3,5-dimethyl-4-hydroxyphenyl)-p-diisopropylbenzol,
2,2-Bis-(3,5-dichlor-4-hydroxyphenyl)-propan,
2,2,-Bis-(3,5-dibrom-4-hydroxyphenyl)-propan,
2,2,-Bis-(4-hydroxyphenyl)-propan,
2,2-Bis-(3,5-dimethyl-4-hydroxyphenyl)-propan
2,2-Bis-(3,5-dichlor-4-hydroxyphenyl)-propan,
2,2-Bis-(3,5-dibrom-4-hydroxyphenyl)-propan,
1,1,-Bis-(4-hydroxyphenyl)-cyclohexan,
4,4'-Dihydroxydiphenyl sulfon,
1,6-,1,7-,2,6-,2,7-Naphthalindiol,
4,4'-Dihydroxydiphenylsulfon und
4,4'-Dihydroxybenzophenon.

- R¹, R², R³, R¹⁰ und R¹²: können unabhängig voneinander variiert werden und stehen vorzugsweise für Wasserstoff, C₁-C₆-Alkyl durch CN oder Halogen, wie Fluor, Chlor, Brom substituiertes C₁-C₆-Alkyl, wie beispielsweise Trifluormethyl, C₁-C₆-Alkoxy, C₁-C₄-Alkoxy substituiertes C₁-C₆-Alkyl, jeweils gegebenenfalls durch C₁-C₄-Alkyl, beispielsweise Methyl, Ethyl, n-oder iso-Propyl, und/oder durch Halogen, wie Fluor, Chlor, Brom substituiertes Phenyl oder Phenyl-C₁-C₄-alkyl, oder gegebenenfalls durch C₁-C₄-Alkyl, beispielsweise Methyl und/oder Ethyl, substituiertes Cyclopentyl oder Cyclohexyl,
- R¹¹: steht vorzugsweise für die gleichen Reste wie R¹⁰ oder R¹², zusätzlich noch für Sulfonyl oder Sulfoxyl, mit Ausnahme von Wasserstoff.

Besonders bevorzugte Polymere sind: 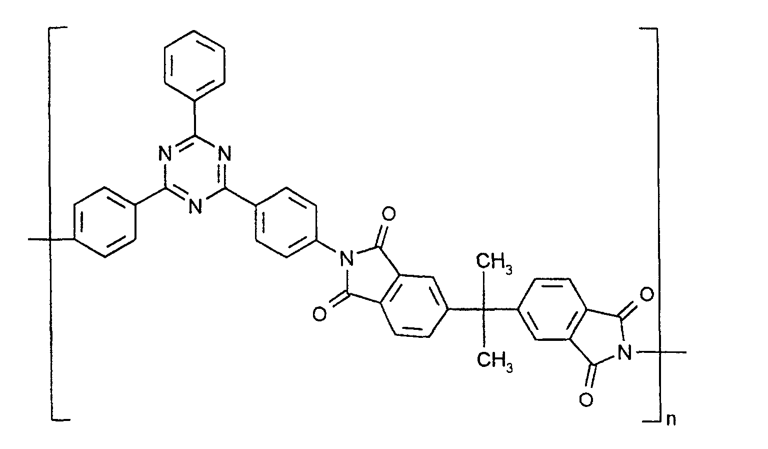 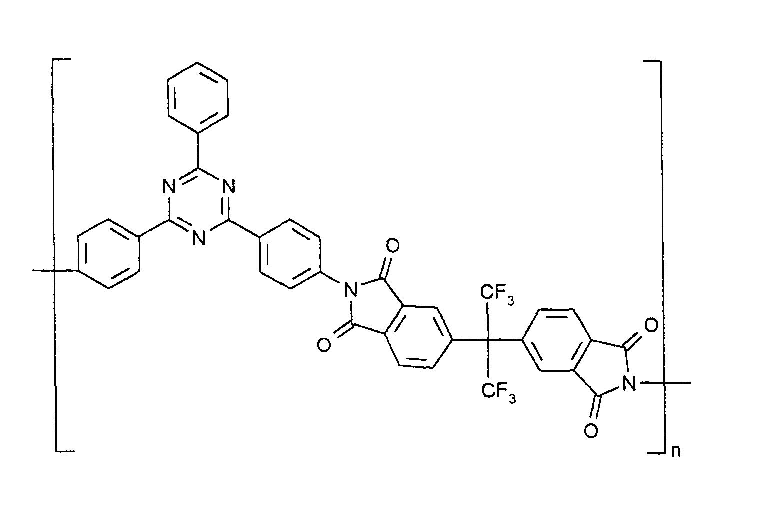 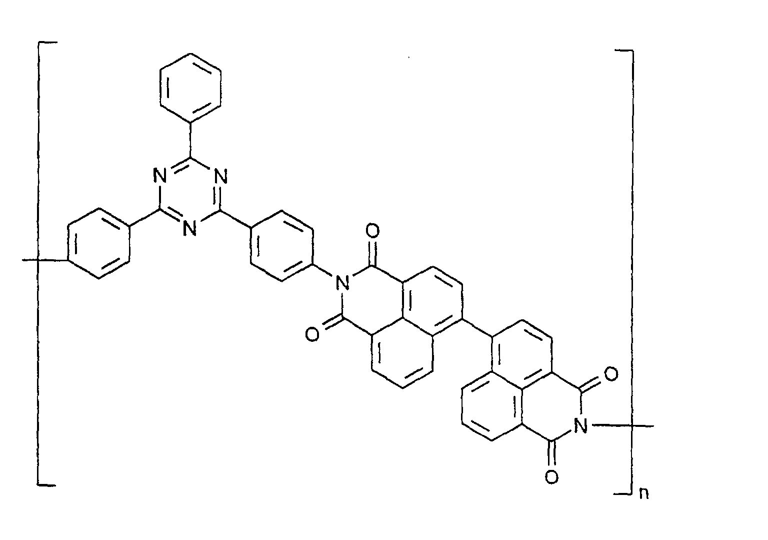 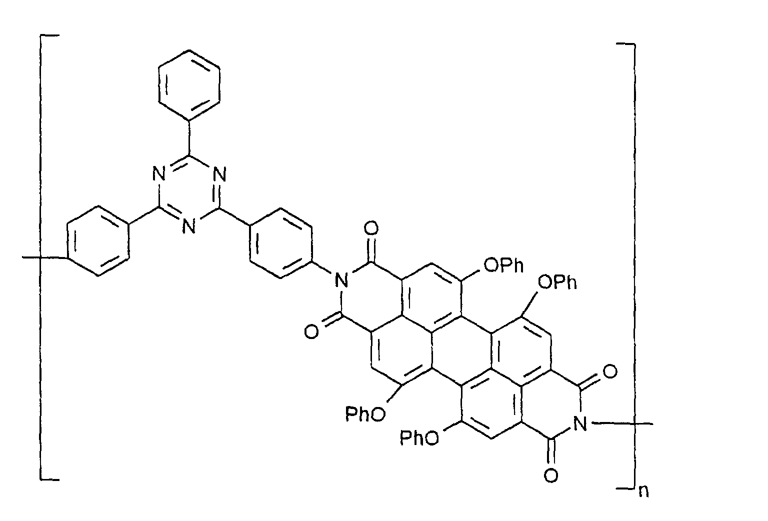 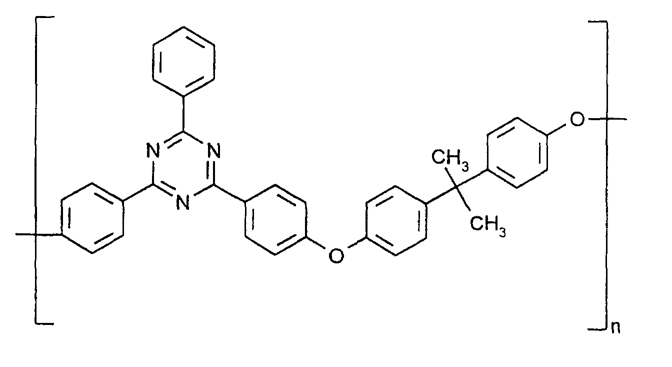 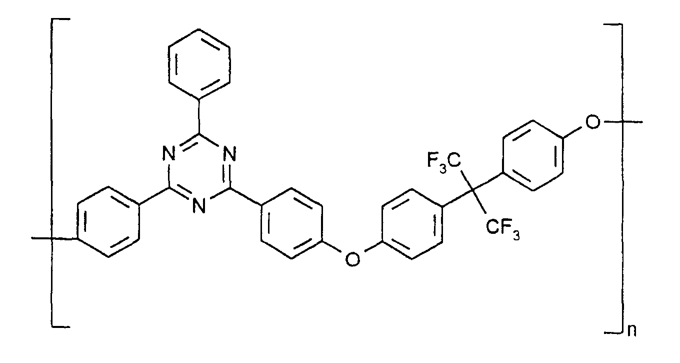 Ph - Phenyl

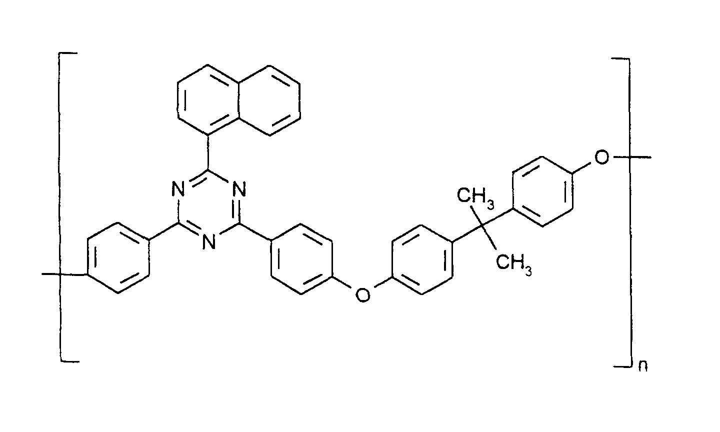

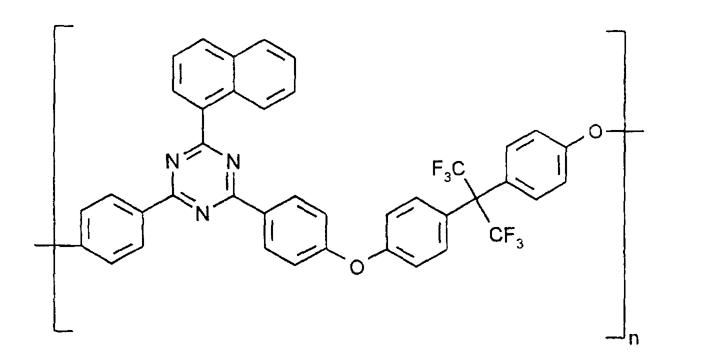

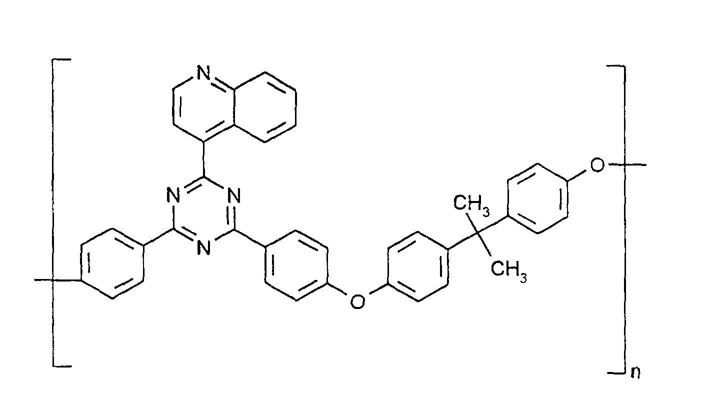

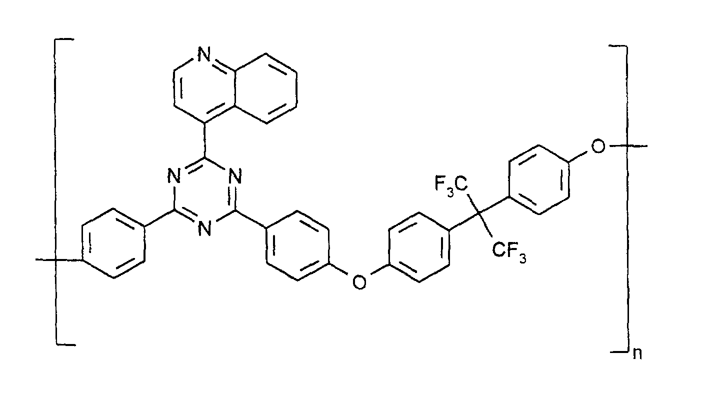

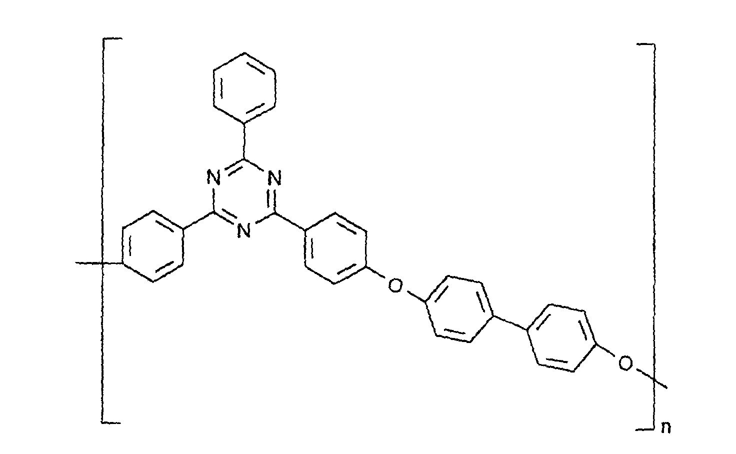

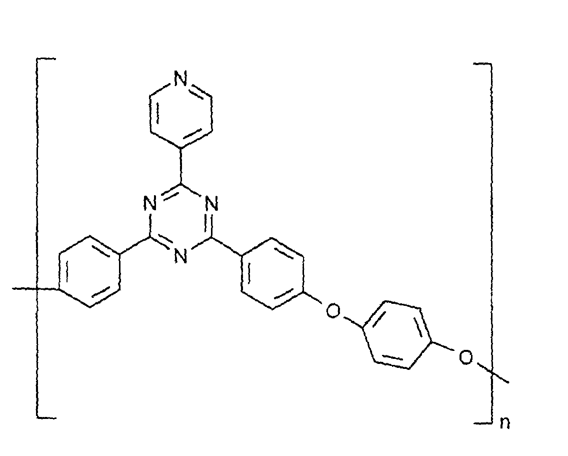

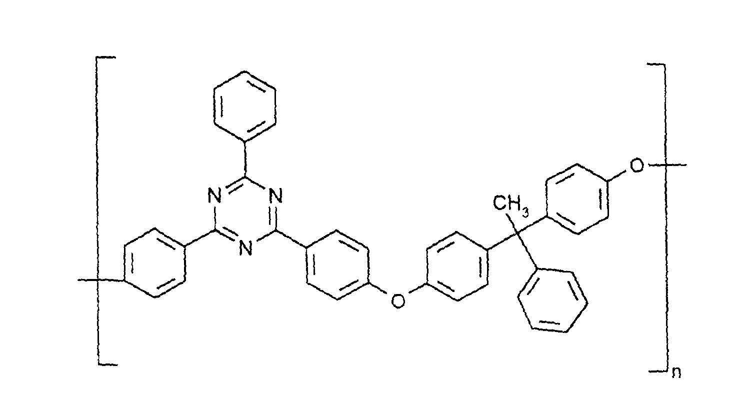

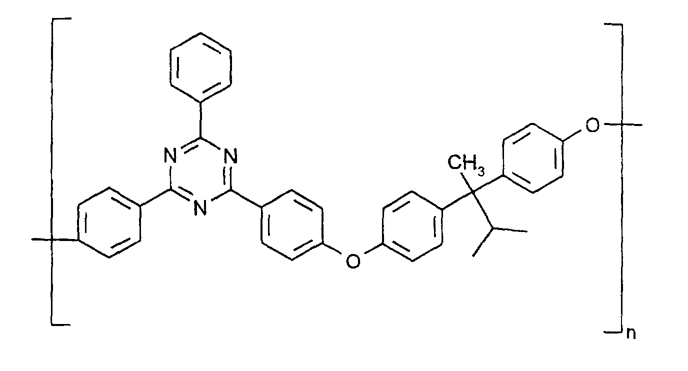

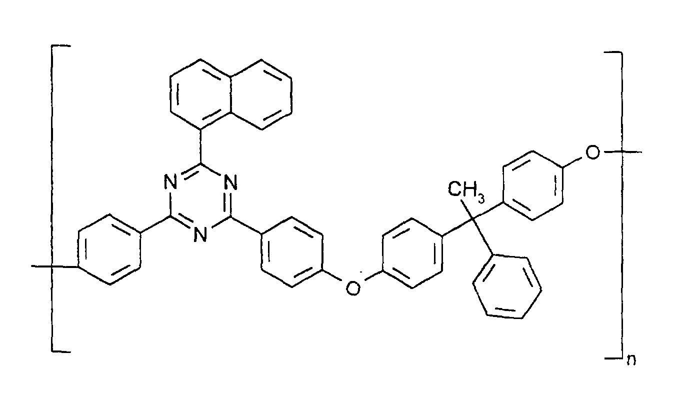

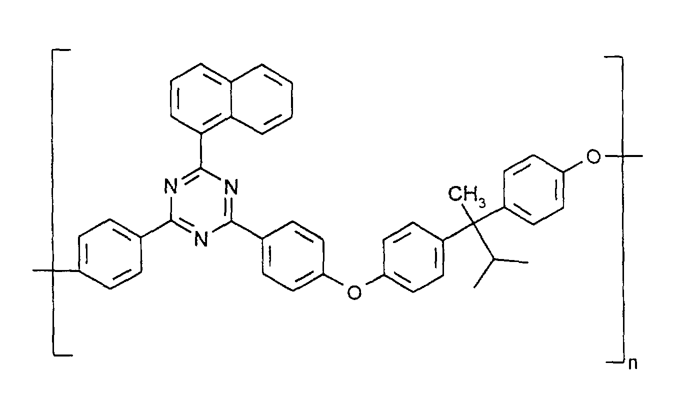

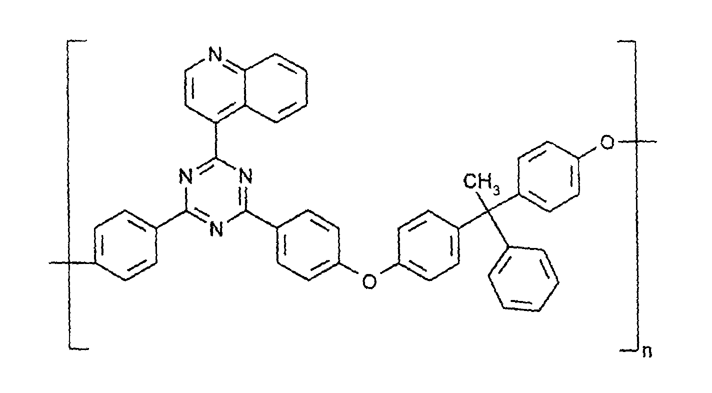

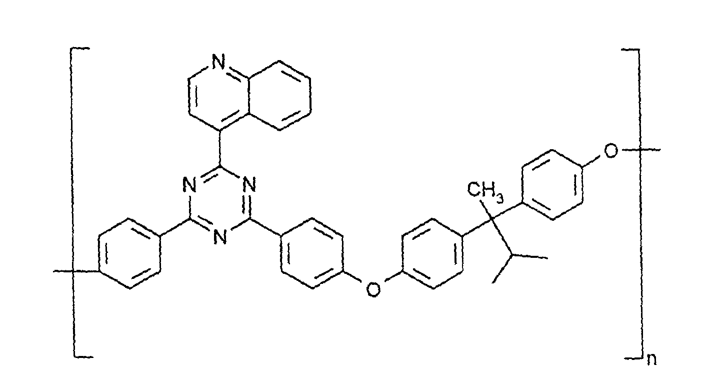

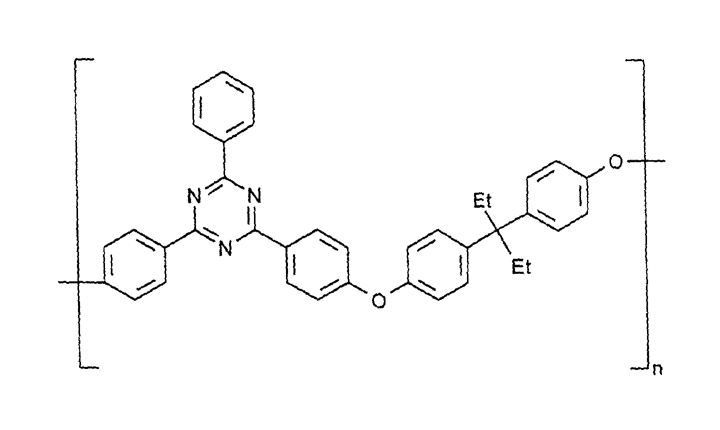

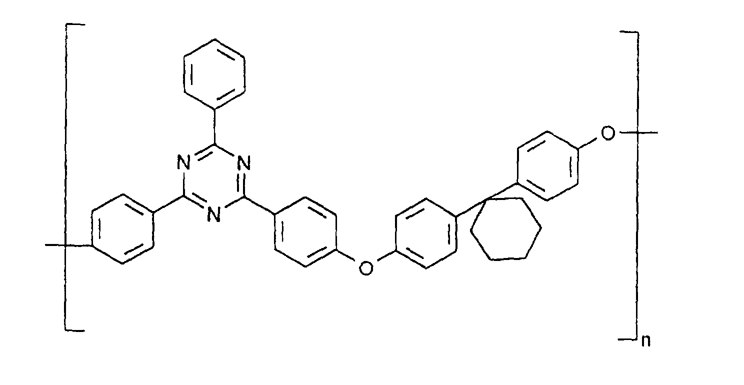

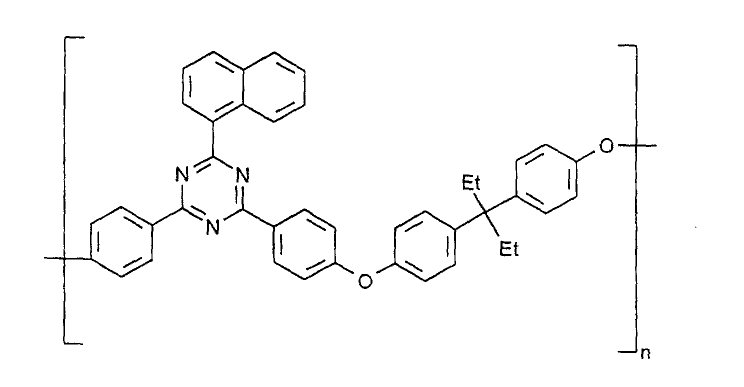

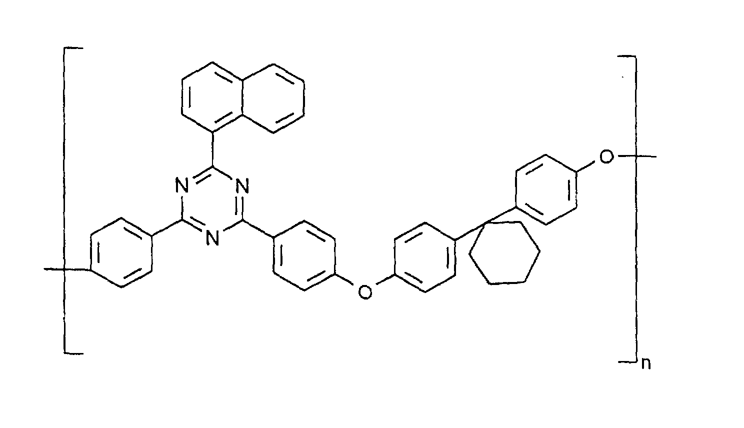

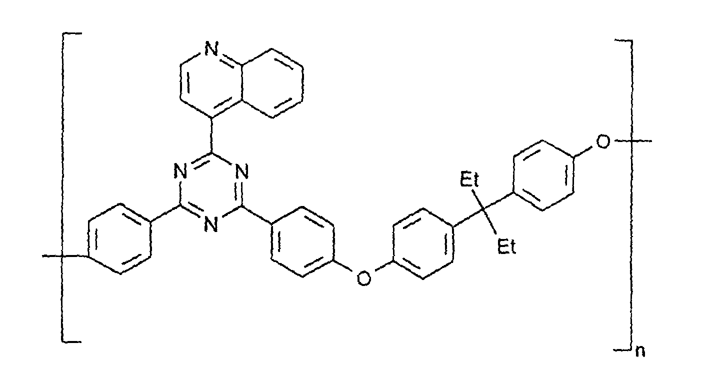

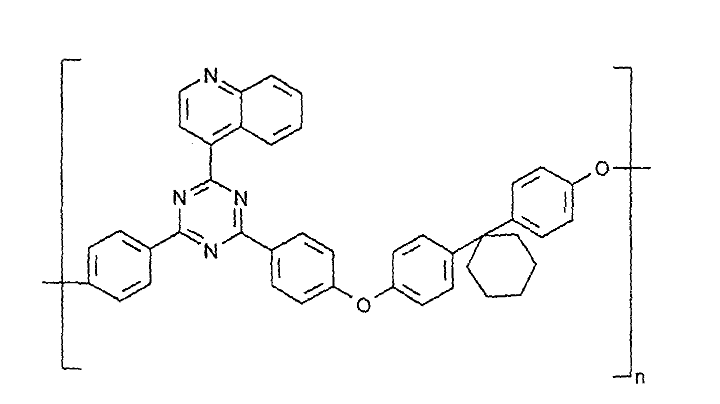

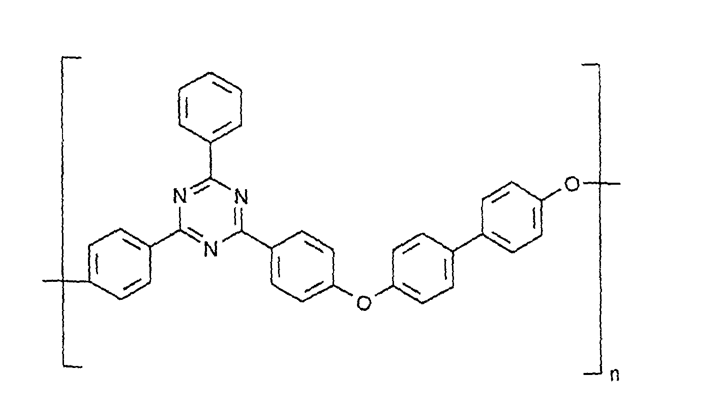

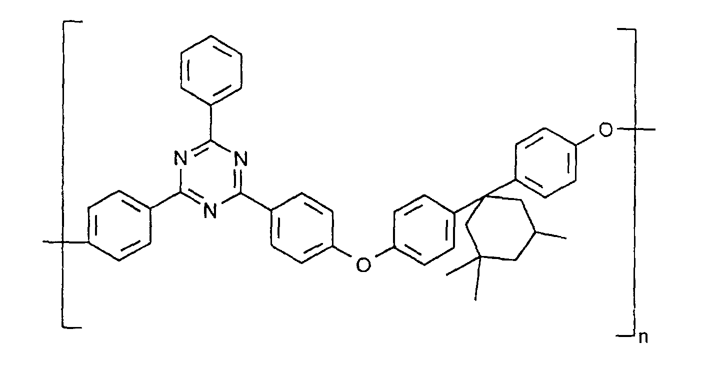

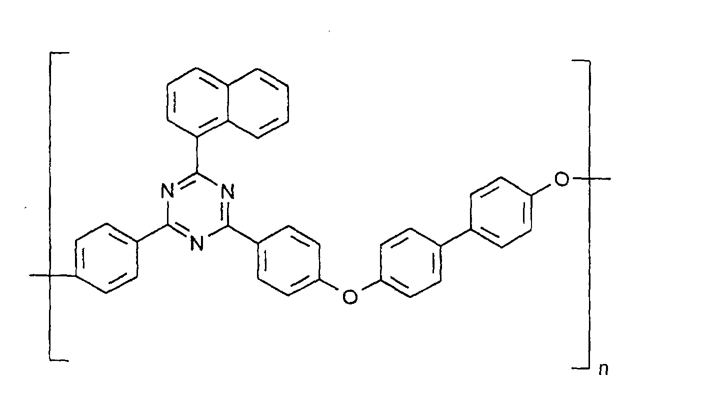

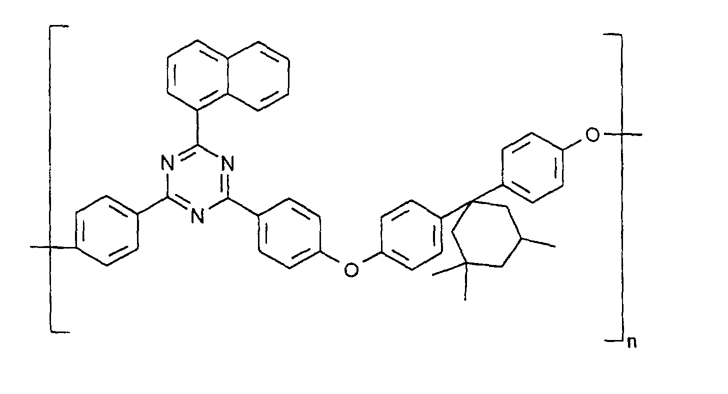

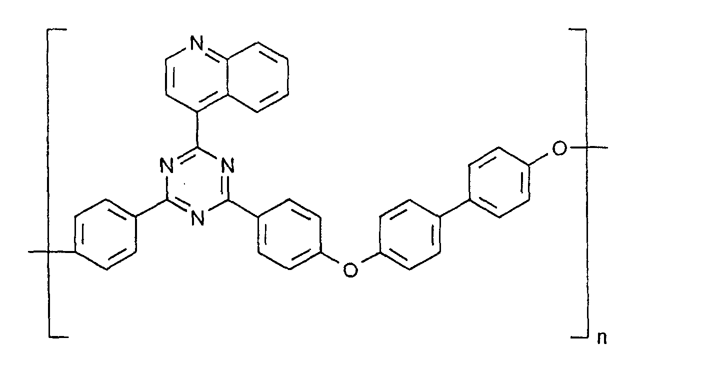

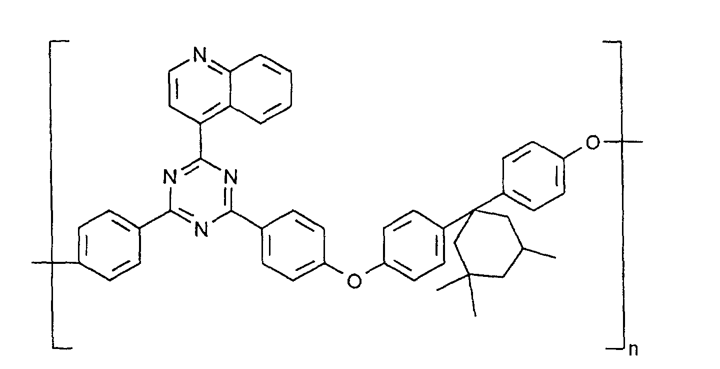

Die erfindungsgemäßen Polymere sind in gängigen Lösungsmitteln wie Alkoholen, Ketonen, Tetrahydrofuran (THF), N-Methylpyrrolidon (NMP), Dimethylformamid (DMF) oder chlorierten Kohlenwasserstoffen löslich.

Zur Herstellung von Schichten aus den erfindungsgemäßen Polymeren werden diese in einem geeigneten Lösemittel gelöst und durch Gießen, Rakeln oder spin-coating auf eine geeignete Unterlage aufgebracht. Dabei kann es sich z.B. um Glas oder ein Kunststoffmaterial handeln, das mit einer transparenten Elektrode versehen ist. Als Kunststoffmaterial kann z.B. eine Folie aus Polycarbonat, Polyester wie Polyethylenterephthalat oder Polyethylennaphthalat, Polysulfon oder Polyimid eingesetzt werden.

Als transparente Elektroden sind geeignet
a) Metallooxide, z.B. Indium-Zinn-Oxid (ITO), Zinnoxid (NESA), Zinkoxid, dotiertes Zinnoxid, dotiertes Zinkoxid, etc.,
b) semi-transparente Metallfime, z.B. Au, Pt, Ag, Cu etc.,
c) leitfähige Polymerfilme wie Polyaniline, Polythiophene, etc.

Die Metalloxid- und die semitransparenten Metallfilmelektroden werden durch Techniken wie Aufdampfen, Aufsputtern, Platinierung, etc., in dünner Schicht aufgebracht. Die leitfähigen Polymerfilme werden durch Techniken wie Spincoaten, Casting, Rakeln etc. aus der Lösung aufgebracht.

Die Dicke der transparenten Elektrode beträgt 30 Å bis etwa mehrere µm, vorzugsweise 100 Å bis 5 000 Å.

Die elektrolumineszierende Schicht wird direkt auf die transparente Elektrode oder auf eine gegebenenfalls vorhandene ladungstransportierende Schicht als dünner Film aufgebracht. Die Dicke des Films beträgt 10 bis 500 nm, vorzugsweise 20 bis 400 nm, besonders bevorzugt 50 bis 250 nm.

Auf die elektrolumineszierende Schicht kann eine weitere ladungstransportierende Schicht eingefügt werden, bevor eine Gegenelektrode aufgebracht wird.

Eine Zusammenstellung von geeigneten ladungstransportierenden Zwischenschichten, bei denen es sich um loch- und/oder elektronenleitenden Materialien handeln kann, die in polymerer oder niedermolekularer Form gegebenenfalls als Blend vorliegen können, ist in EP-A 532 798 aufgeführt. Besonders geeignet sind speziell substituierte Polythiophene, die über lochtransporierende Eigenschaften verfügen. Sie sind beispielsweise in EP-A 686 662 beschrieben.

Der Gehalt an niedermolekularem Lochleiter in einem polymeren Binder ist im Bereich von 2 bis 85 Gew.-% variierbar; bevorzugt beträgt der Gehalt 5 bis 75 Gew.-%, besonders bevorzugt 10 bis 70 Gew.-%. Filmbildende Lochleiter können auch in reiner Form (100 %ig) eingesetzt werden.

Der Gehalt an niedermolekularen Elektronenleitern im polymeren Binder ist im Bereich von 2 bis 85 Gew.-% variierbar; bevorzugt beträgt der Gehalt 5 bis 75 Gew.-%, besonders bevorzugt 10 bis 70 Gew.-%. Filmbildende Elektronenleiter können auch in reiner Form (100 %ig) eingesetzt werden.

Die Gegenelektrode besteht aus einer leitfähigen Substanz, die transparent sein kann. Vorzugsweise eignen sich Metalle, z.B. Al, Au, Ag, Mg, In, etc. oder Legierungen und Oxide dieser, die durch Techniken wie Aufdampfen, Aufsputtern, Platinierung aufgebracht werden können.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 0,1 bis 100 Volt Licht der Wellenlänge von 200 bis 2000 nm. Sie zeigen im Bereich von 200 bis 2000 nm Photolumineszenz.

Die erfindungsgemäßen Anordnungen sind zur Herstellung von Einheiten zur Beleuchtung und zur Informationsdarstellung geeignet.

Die Herstellung der Triazinpolymere erfolgt nach allgemein bekannten Methoden, vgl. z.B. H. R. Kricheldorf, Handbook of Polymer Synthesis, Part A, Kapitel 9 und Part B, Kapitel 15, (1992).

### 5-Ring Polyimide:

Das entsprechende s-Triazin Diamin wird zusammen mit einer stöchiometrischen Menge des 5-Ring-Di-Anhydrids in NMP vorgelegt (10 Gew.-%) und zunächst 4 Stunden bei Raumtemperatur gerührt. Die gebildete Polyamidcarbonsäure kann durch Fällen in Methanol gewonnen werden. Eine Imidisierung wird durch mehrstündiges Heizen der viskosen Mischung auf 200°C erreicht. (Vorschrift analog "Handbook of Polymer Synthesis", Part B, Kapitel 15, Seite 941, H.R. Kricheldorf 1992))

### 6-Ring Polyimide:

Das entsprechende s-Triazin Diamin wird zusammen mit einer stöchiometrischen Menge des 6-Ring-Di-Anhydrids in m-Kresol und einer katalytischen Menge Isochinolin vorgelegt (10 Gew.-%) und 24 Stunden auf 200°C erhitzt. Das Polymer wird in Methanol ausgefällt. (Vorschrift analog "Handbook of Polymer Synthesis", Part B, Kapitel 15, Seite 911, H. R. Kricheldorf (1992))

### Polyether:

Das entsprechende Di-halo-s-triazin wird mit einer stöchiometrischen Menge eines Diphenols in bevorzugt NMP oder Diphenylsulfon (10 Gew.-%) mit einer dem Diphenol entsprechenden Menge Kaliumcarbonat vorgelegt und mit Toluol am Wasserabscheider für 3 Stunden zum Rückfluß erhitzt. Nach Abdestillieren des Toluols wird nochmals 5 bis 12 Stunden erhitzt und dann in Methanol gefällt. (Vorschrift analog "Handbook of Polymer Synthesis", Part A, Kapitel 8, Seite 545, H. R. Kricheldorf (1992))

Im folgenden sind ausgewählte Poly-s-Triazinether hinsichtlich ihrer Synthese und ihrer Eigenschaften erwähnt:

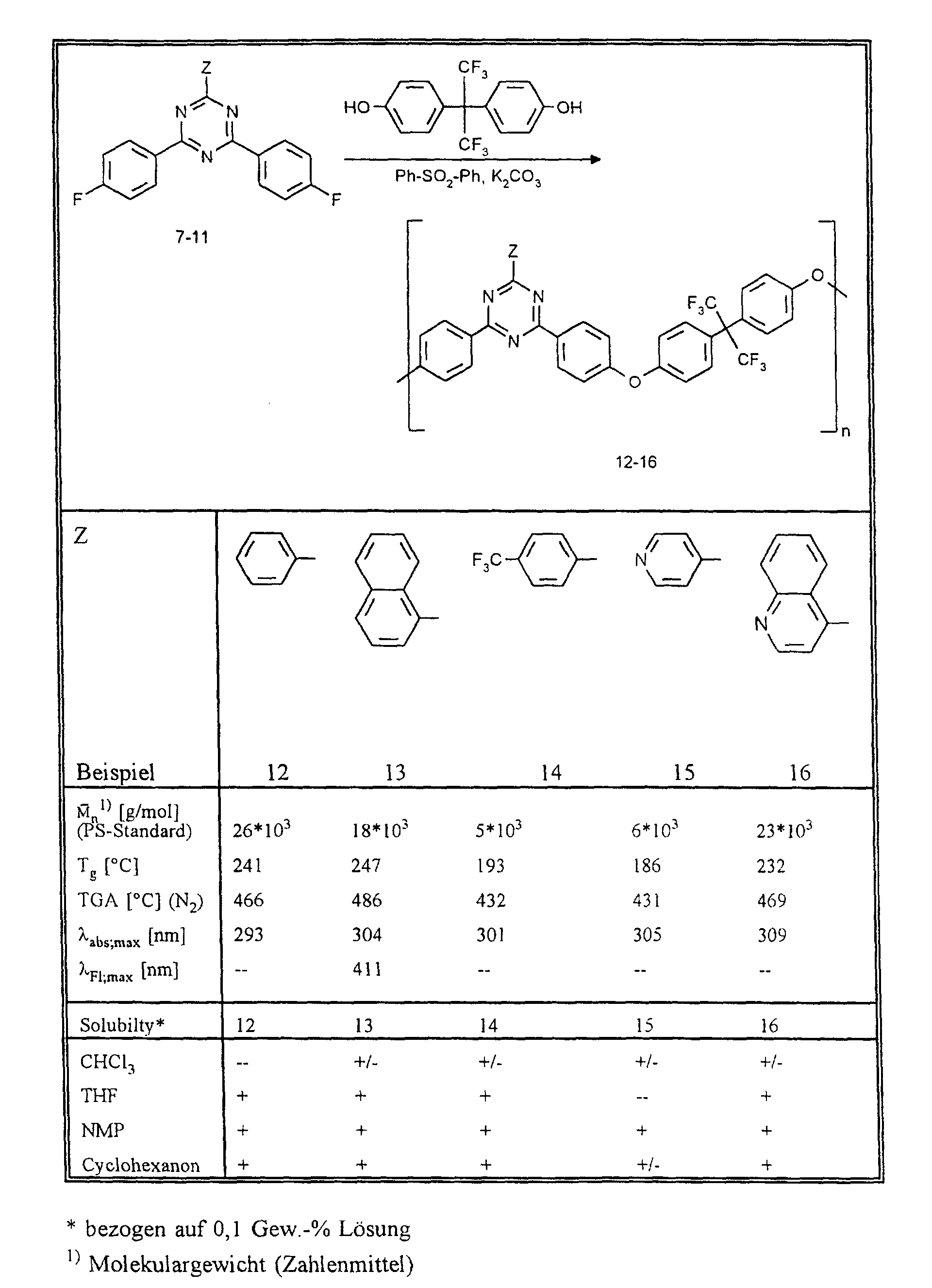

### Darstellung der Ausgangsverbindungen

### Beispiele

N-Benzylidenanilin (Aldrich) (1),
4-Trifluormethyl-N-benzylidenanilin (2),
N-(4-Pyridylen)-aniline (3),
N-(6-Chinolyden)-aniline (4),
N-(1-Naphthyliden)-aniline (5)

Anilin und der dazu korrespondierende Aldehyd werden in einer stöchiometrischen Menge in Chloroform (10 bis 30 gew.-%ig) gelöst und 3 h am Wasserabscheider zu Rückfluß erhitzt. Die resultierende gelbe Lösung wird bis zur Trockne eingeengt und am Hochvakuum getrocknet. Ausbeute: 99 % der Theorie
¹H-NMR (CDCl₃):
(2) δ = 8,74 (1H), 8,75 (2H, arom.), 7,81 (2H, arom.), 7,28 (5H, arom.);
(3) δ = 8,75 (2H, arom.), 8,44 (1H), 7,71 (2H, arom.), 7,28 (5H, arom.);
(4) δ = 9,11 (1H), 9,04 (1H, arom.), 8,85 (1H, arom.), 8,20 (1H, arom.), 7,91 (1H, arom.), 7,63 (2H, arom.), 7,35 (5H, arom.);
(5) δ = 9,09 (1H), 9,01 (1H, arom.), 7,91 (3H, arom.), 7,51 (2H, arom.), 7,29 (5H, arom.)

### 4-Fluor-benzamidin-hydrochlorid (7)

4-Fluorbenzoesäurenitril (200 mmol) und Ethanol (205 mmol) werden in 100 ml Benzol gelöst. Durch die Lösung werden ca. 40 min HCl geleitet, weitere 3 Stunden bei Raumtemperatur gerührt und in 11 Diethylether gefällt. Das farblos anfallende Produkt wird abgesaugt und getrocknet. Ausbeute: 52 % der Theorie.

Das so entstandene 4-Fluor-benzimidoester-Hydrochlorid (100 mmol) wird dann in 250 ml ammoniakalischem Ethanol suspendiert und solange bis auf 50°C erhitzt, bis sich alles gelöst hat. Anschließend wird das Lösungsmittel abgezogen und das farblose Produkt getrocknet. Ausbeute: 98 % der Theorie.
¹H-NMR (d⁶-DMSO): δ = 9,41 (4H), 8,01 (4H, arom.)
4,4'-Difluor-2,4,6-triphenyl-1,3,5-triazin (8),
4,4'-Difluor-4"-trifluormethyl-2,4,6-triphenyl-1,3,5-triazin (9)
4,4'-Difluor-2,4-diphenyl-6-(1-naphthyl)-1,3,5-triazin (10),
4,4'-Difluor-2,4-diphenyl-6-(6-pyridyl)-1,3,5-triazin (11),
4,4'-Difluor-2,4-diphenyl-6-(6-chinolyl)-1,3,5-triazin (12)

50 mmol 4-Fluor-benzamidin und 23 mmol des korrespondierenden Anilidens werden in 40 ml DMF für 24 Stunden auf 80°C erhitzt. Nach Abkühlen auf Raumtemperatur wird in 1 l Methanol gefällt, das farblose Produkt abgesaugt und durch Sublimation (220 bis 290°C; 10⁻⁶ mbar) aufgereinigt. Ausbeute: 23 bis 48 % der Theorie)
¹H-NMR (C₂D₂Cl₄):
(8) δ = 8,65 (6H, arom.), 7,55 (3H, arom.), 7,20 (4H, arom.);
(9) δ = 8,75 (6H, arom.), 7,98 (2H, arom.), 7,43 (4H, arom.);
(10) δ = 9,12 (1H, arom.), 8,75 (4H, arom.), 8,50 (1H, arom.), 8,05 (2H, arom.), 7,62 (3H, arom.), 7,21 (4H, arom.);
(11) δ = 8,85 (2H, arom.), 8,70 (4H, arom.), 8,49 (2H, arom.), 7,21 (4H, arom.);
(12) δ = 9,15 (1H, arom.), 8,98 (1H, arom.), 8,65 (4H, arom.), 8,21 (2H, arom.), 7,62 (2H, arom.), 7,15 (4H, arom.)

### 3,3'-Diamino-2,4,6-triphenyl-1,3,5-triazin (17)

3-Nitro-benzamidin (Adrich) (48 mmol) und N-Benzylidenanilin (1) (22 mmol) werden in 200 ml Ethanol 24 Stunden bei 60°C erhitzt und das ausfallende farblose 3,3'-Dinitro-2,4,6-triphenyl-1,3,5-triazin wird abgesaugt und im Vakuum getrocknet. Ausbeute: 74 % der Theorie.
¹H-NMR (C₂D₂Cl₄):
(17) δ = 9,40 (2H, s), 9,05 (2H, d), 8,70 (2H, d), 8,45 (2H, d), 7,75 (2H, m), 7,15 (3H, m)

Das so entstandene 3,3'-Dinitro-2,4,6-triphenyl-1,3,5-triazin (5 mmol) wird in 50 ml Ethanol und 20 ml konzentrierter Salzsäure mit 8 g SnCl₂*2H₂O 8 Stunden zum Rückfluß erhitzt, abfiltriert und im Vakuum getrocknet. Ausbeute: 81 % der Theorie.

Das freie Amin wird durch Dispergieren in 5 %iger NaOH H₂O/Ethanol (1:1) und leichtes Erhitzen erhalten.
¹H-NMR (d⁶-DMSO):
(14) δ = 8,70 (2H, d), 7,90 (2H, s), 7,85 (2H, d), 7,65 (3H, m), 7,25 (2H, t), 6,85 (2H, d), 5,35 (4H, s)

### Polyether:

Das entsprechende Di-halo-s-triazin wird mit einer stöchiometrischen Menge eines Diphenols in bevorzugt NMP oder Diphenylsulfon (10 Gew.-%) mit einer dem Diphenol entsprechenden Menge Kaliumcarbonat vorgelegt und mit Toluol am Wasserabscheider für 3 Stunden zum Rückfluß erhitzt. Nach Abdestillation des Toluols wird nochmals 5 bis 12 Stunden auf 200°C erhitzt und dann in Methanol gefällt (Vorschrift analog "Handbook of Polymer Synthesis", Part A, Kapitel 8, H. R. Kricheldorf).

### 6-Ring Polyimide (18)

Das entsprechende s-Triazin Diamin wird zusammen mit einer stöchiometrischen Menge des 5-Ring-Di-Anhydrids in m-Kresol und einer katalytischen Menge Isochinolin vorgelegt (10 Gew.-%) und 24 Stunden auf 200°C erhitzt. Das Polymer wird in Methanol ausgefällt (Vorschrift analog "Handbook of Polymer Synthesis", Part B, Kapitel 15, H. R. Kricheldorf).

### Beispiel 18:

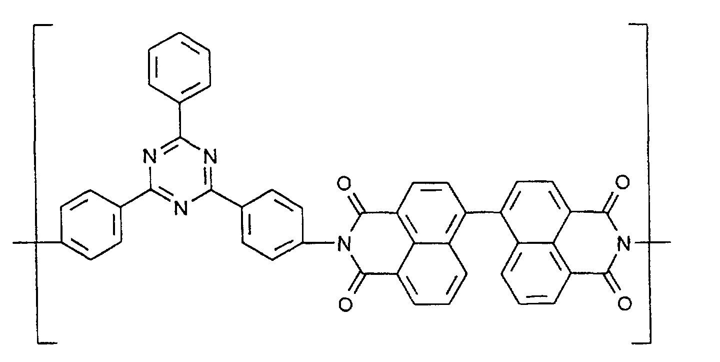

¹H-NMR (CDCl₃: CF₃COOD (2:1): δ = 8,5 - 9,1 (arom., m), 7,6 - 8,1 (arom., m)
Löslichkeit in Trifluoressigsäure und Pentafluorphenol (>> 0,1 Gew.-%)

### 5-Ring Polyimide (19/20)

Das entsprechende s-Triazin Diamin wird zusammen mit einer stöchiometrischen Menge des 5-Ring-Di-Anhydrids in NMP vorgelegt (10 Gew.-%) und zunächst 4 Stunden bei Raumtemperatur gerührt. Die gebildete Polyamidcarbonsäure kann durch Fällen in Methanol gewonnen werden (19). Eine Imidisierung wird durch mehrstündiges Heizen der viskosen Mischung auf 200°C erreicht (Vorschrift analog "Handbook of Polymer Synthesis", Part B, Kapitel 15, H. R. Kricheldorf) und anschließender Fällung in Aceton (20).

### Beispiel 20

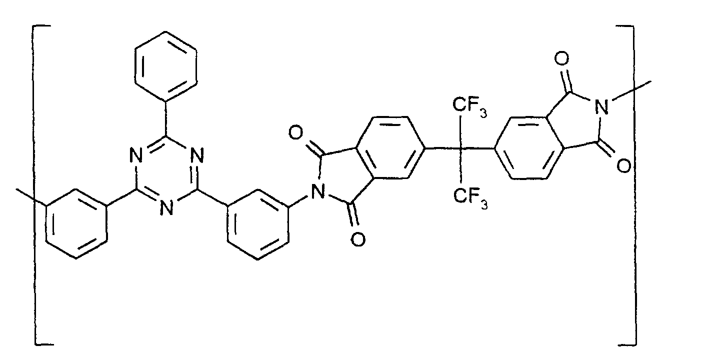

¹H-NMR (d⁶-DMSO): (19) δ = 10,80 (s, Amid-H), 7,60 - 8,85 (arom., m)
¹H-NMR (CDCl₃): (20) δ = 7,60 - 8,85 (arom., m)

### s-Triazin-Polymere in LEDs:

### ITO/PPV (100 nm) Beispiel (16) (100 nm)/Aluminium (1000 nm)

Als Lochleiter wird PPV verwendet (Precursorpolymer/gerakelt mit 150 µm Spalt/thermisch 3 Stunden bei 160°C eliminiert). Hierauf wird der Polyether (16) aus Cyclohexanon (0,3 Gew.-%) gerakelt (80 µm Spalt/75°C). Es wird eine Strom/Spannungskurve aufgenommen, die das Dioden-Verhalten mit und ohne Beispiel 16 charakterisiert.

| | Onset Voltage [V] | PM*ₘₐₓ [A] | Iₘₐₓ [A] |
|---|---|---|---|
| ITO/PPV/Al | 3 | 5*10⁻¹⁰ | 300 |
| ITO/PPV/Beisp.16/Al | 4 | 4*10⁻⁶ (=200 Cd/m2) | 50 |

| | | | |
|---|---|---|---|
| (* A an 200 V/stair pulse 3s/5s delay) | | | |

## Patentansprüche

1. Polymere und/oder Copolymere mit wiederkehrenden Einheiten der Formel (I) 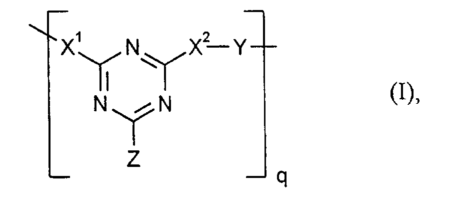 wobei die Reste X¹, X², Y, Z voneinander unabhängig variierbar sind,
q für eine ganze Zahl von 3 bis 1 000,
X¹ und X² unabhängig voneinander für -O-, -NH-, Phenyl oder eine chemische Bindung stehen und
Y für einen 2-bindigen Rest steht, ausgewählt aus 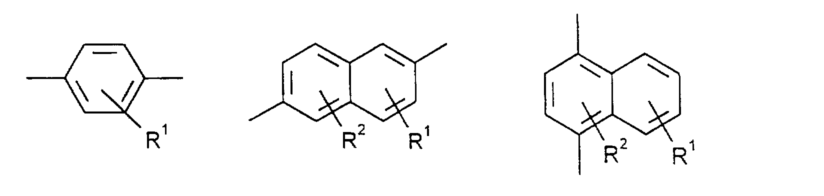 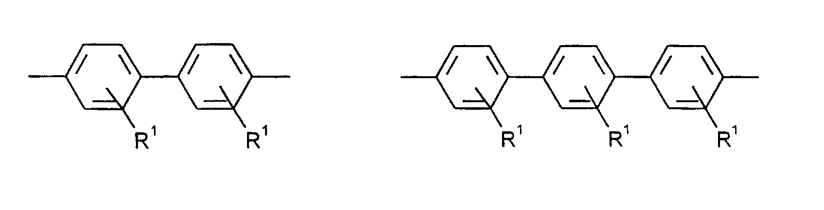 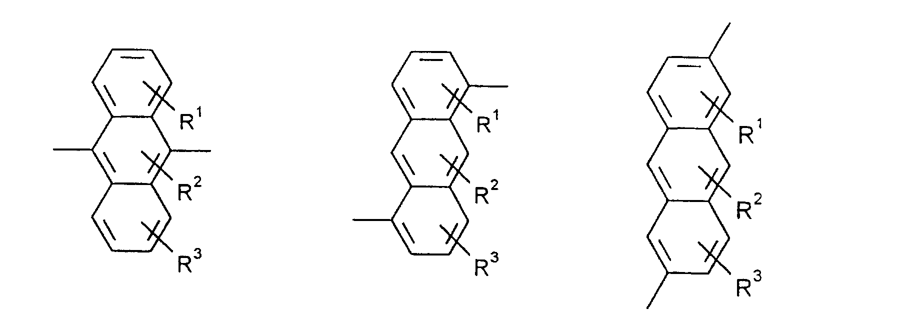 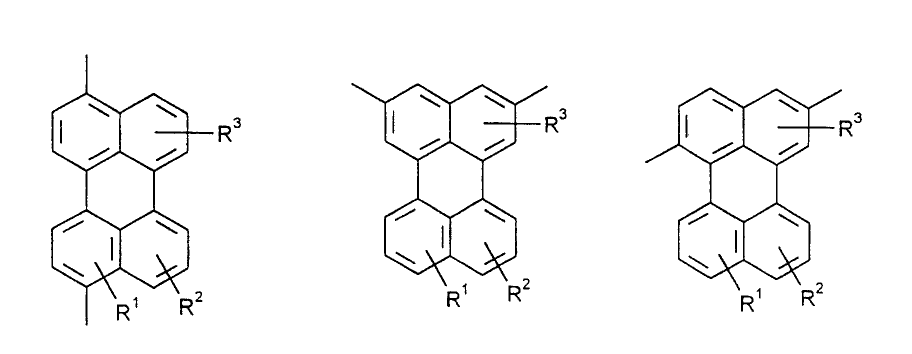 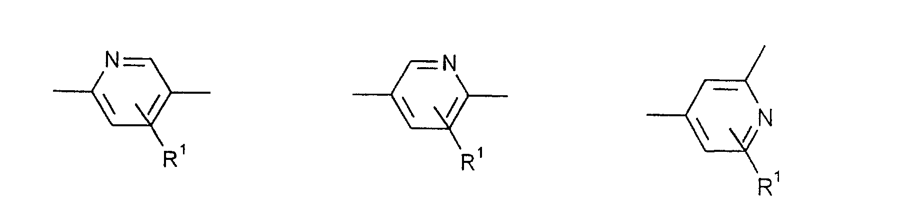 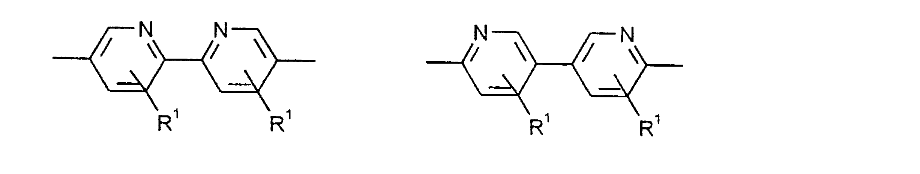 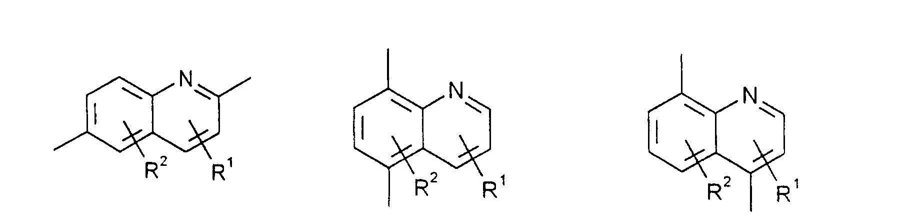 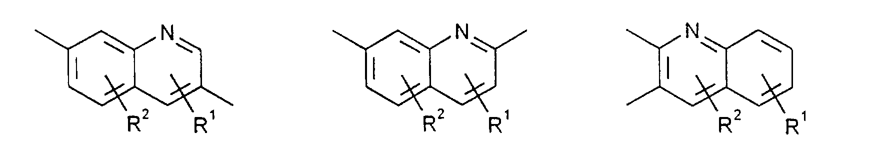 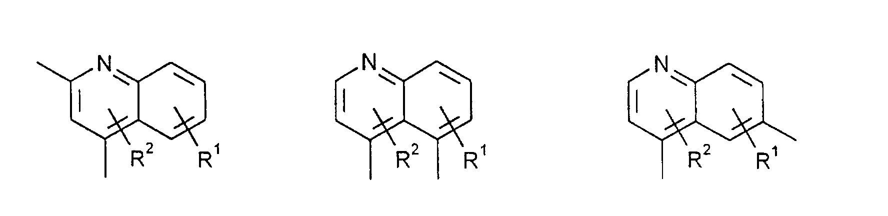 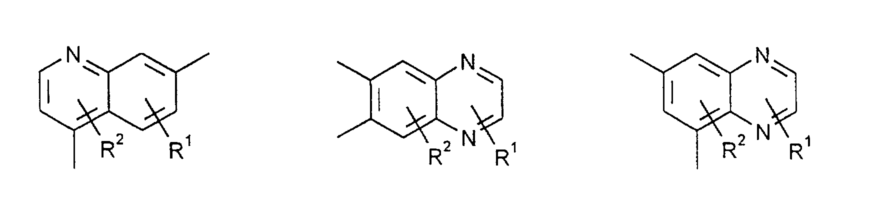 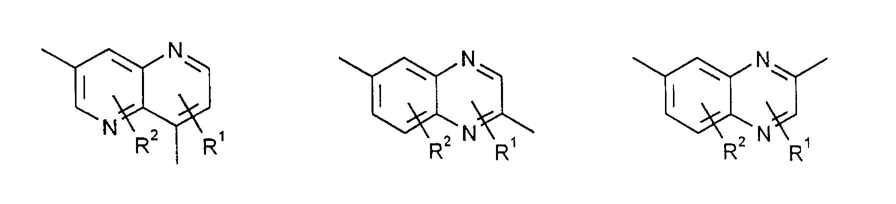 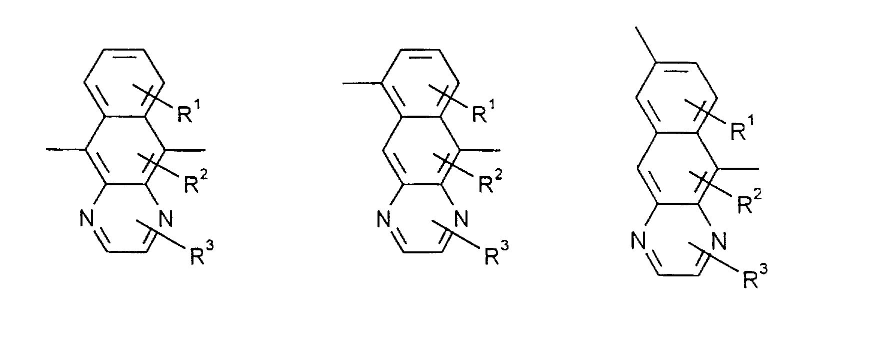 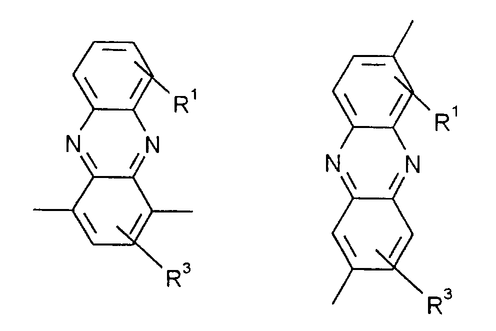 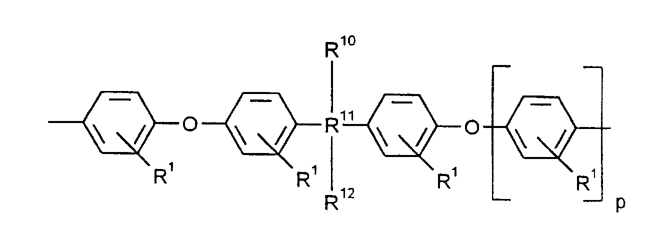 mit p = 0 oder 1 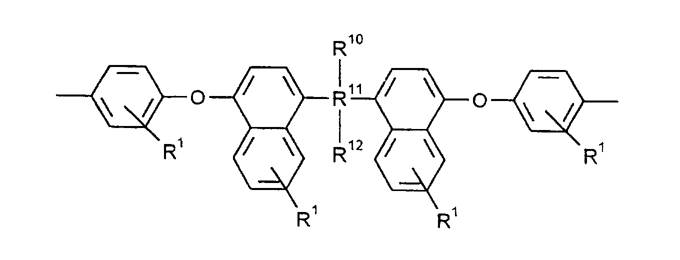 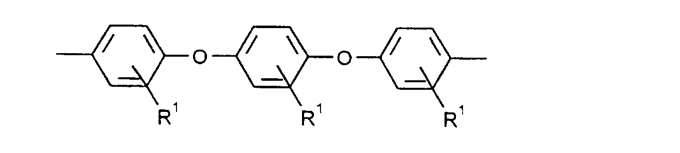 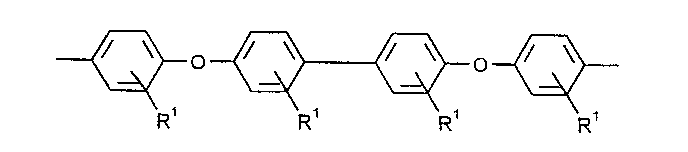 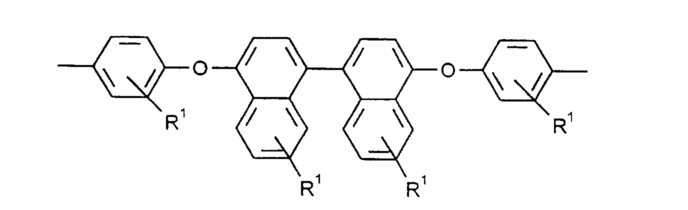 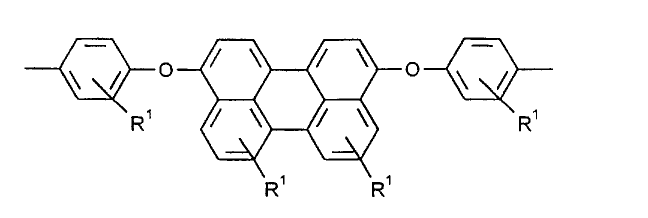 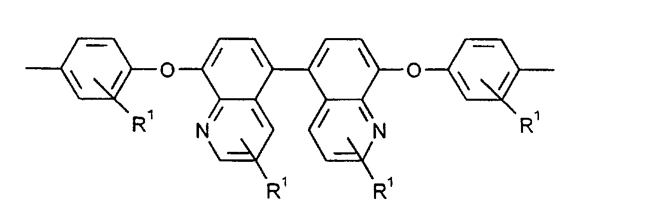 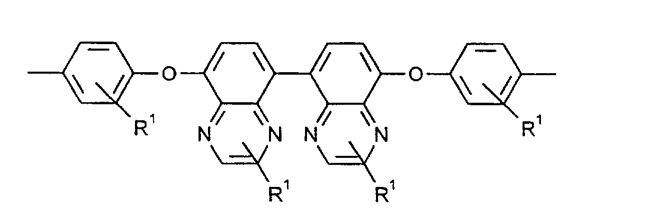 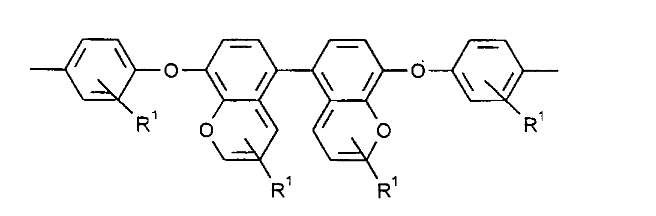 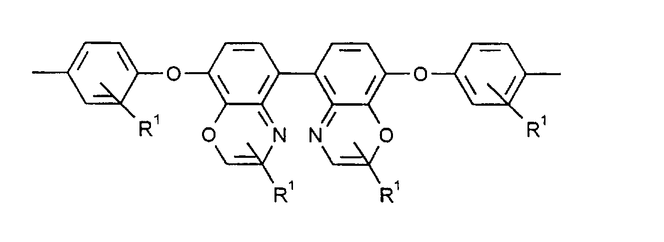 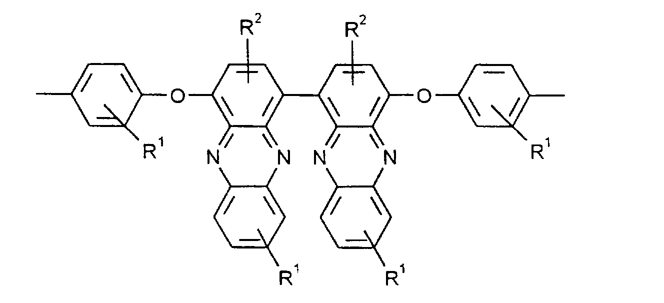 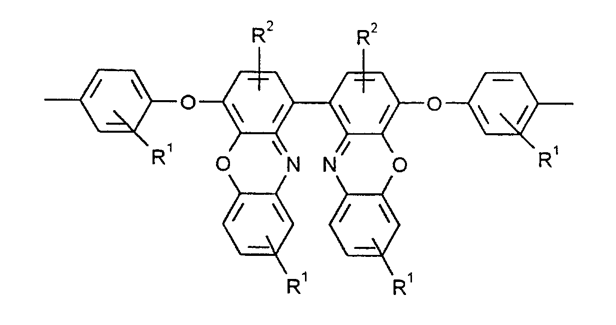 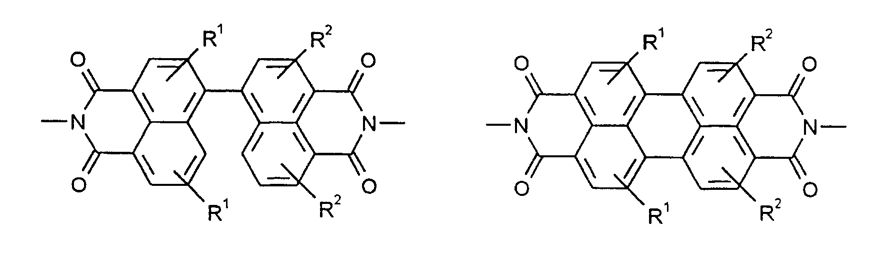 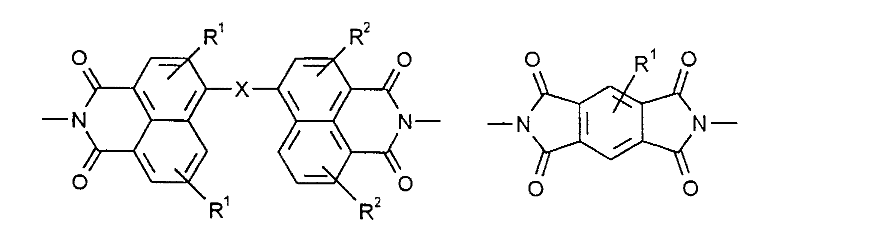 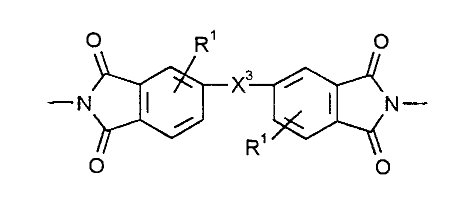
wobei X³ für 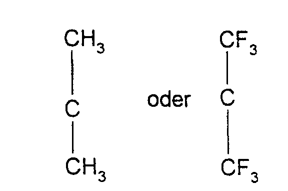 steht, 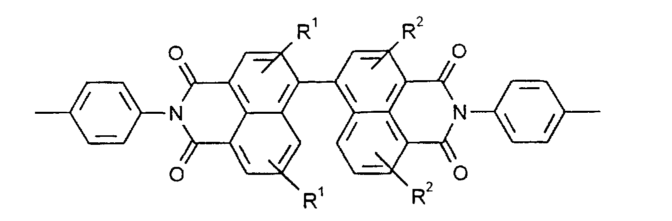 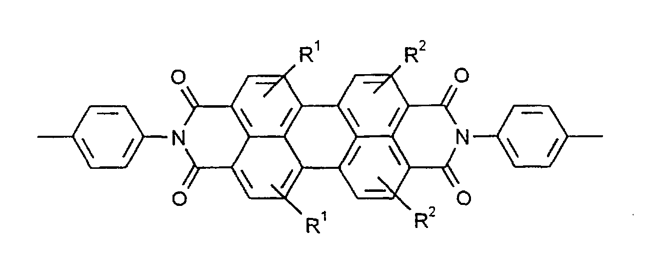 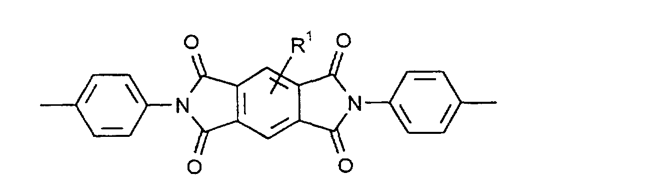
wobei
R¹, R², R³, R¹⁰ und R¹² unabhängig voneinander für Wasserstoff, gegebenenfalls substituiertes C₁-C₁₀-Alkyl, C₁-C₁₀-Alkoxy, Alkoxycarbonyl-substituiertes C₁-C₁₀-Alkyl, jeweils gegebenenfalls substituiertes Aryl, Aryl-C₁-C₆-alkyl oder Cycloalkyl stehen,
R¹¹ für die gleichen Reste wie R¹⁰ oder R¹² mit Ausnahme von Wasserstoff steht, wobei R¹¹ zusätzlich für Sulfonyl oder Sulfoxyl stehen kann, oder
Y für einen Rest der Formel (II) steht 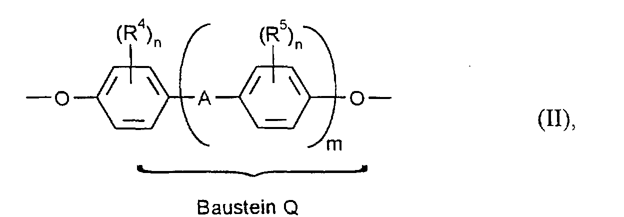
wobei
R⁴ und R⁵ gleich oder verschieden sind und für Halogen, C₁-C₄-Alkyl, C₆-C₁₂-Aryl oder C₇-C₁₂-Aralkyl stehen,
n 0 oder eine ganze Zahl von 1 bis 4 bedeutet,
A für eine chemische Bindung, CO, O, S, SO₂ oder einen Rest der Formel (III) oder (IV) 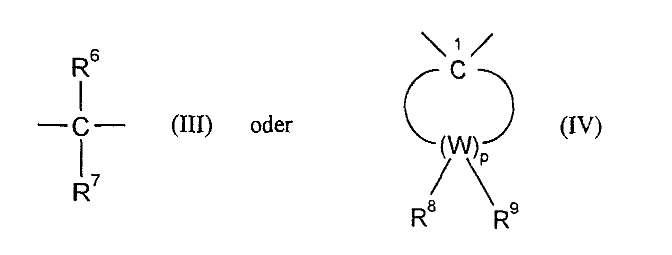 steht, worin
R⁶ und R⁷ gleich oder verschieden sind und für Wasserstoff, Halogen, C₁-C₄-Alkyl, Halogen-C₁-C₄-alkyl, oder C₅-C₁₂-Cycloalkyl mit gegebenenfalls einem oder mehreren Alkylsubstituenten, stehen,
p eine ganze Zahl von 4 bis 7 ist,
R⁸ und R⁹ für jedes W individuell wählbar sind und unabhängig voneinander Wasserstoff oder C₁-C₆-Alkyl, bedeuten und
W Kohlenstoff bedeutet,
mit der Maßgabe, daß an mindestens einem Atom W die Reste R⁸ und R⁹ gleichzeitig Alkyl sind,
m 0 oder eine ganze Zahl von 1 bis 3 bedeutet,
Z für Wasserstoff, Halogen, CN, gegebenenfalls durch Halogen substituiertes C₁-C₂₀-Alkyl, C₁-C₁₀-Alkoxycarbonyl substituiertes C₁-C₁₀-Alkyl, jeweils gegebenenfalls durch Halogen, C₁-C₆-Alkyl, Halogen-C₁-C₆-alkyl und/oder C₁-C₆-Alkoxy substituiertes C₆-C₁₀-Aryl, Aryl-C₁-C₆-alkyl, Pyridyl oder Isochinolyl, C₄-C₁₀-Cycloalkyl oder einen Rest der Formel 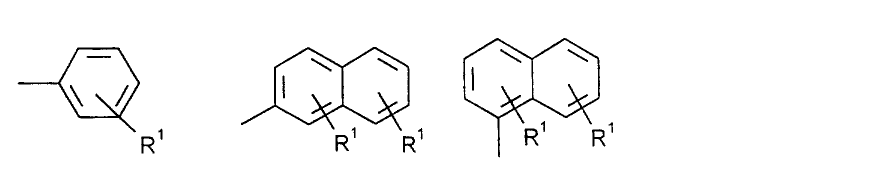 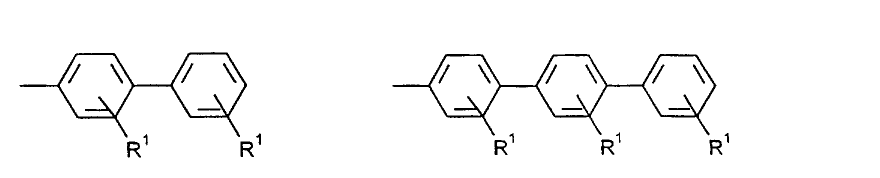 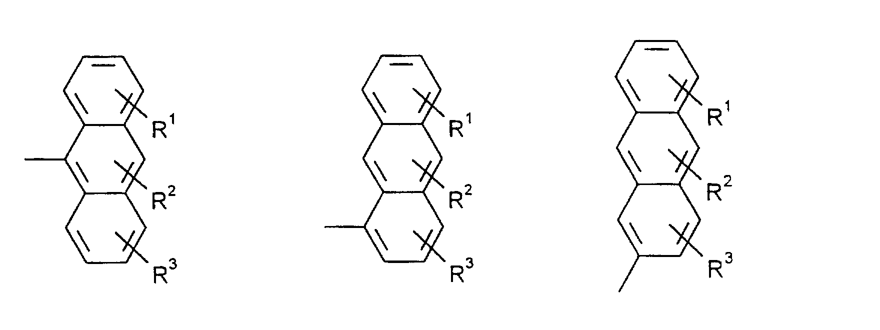 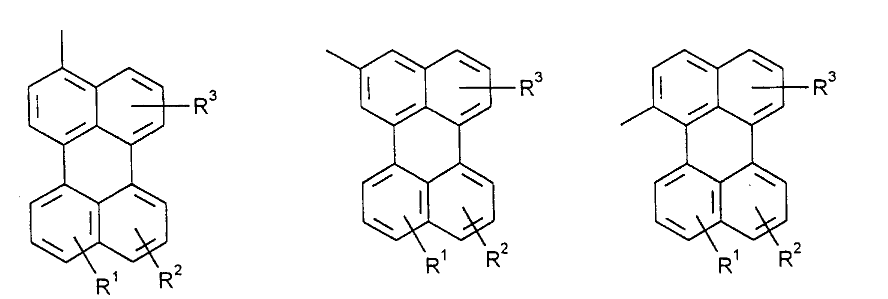 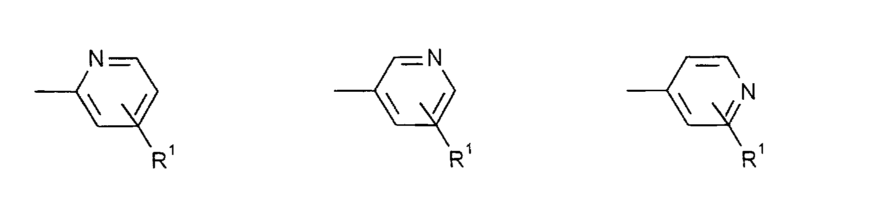 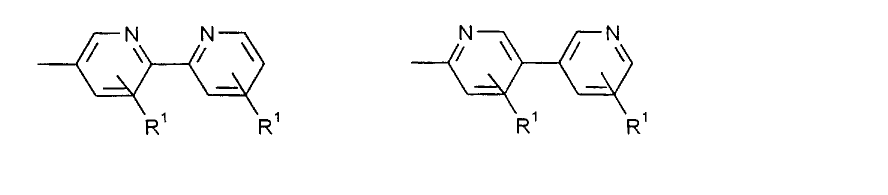 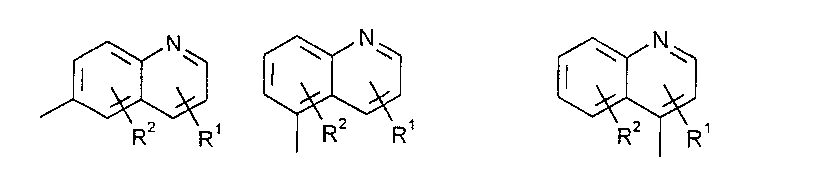 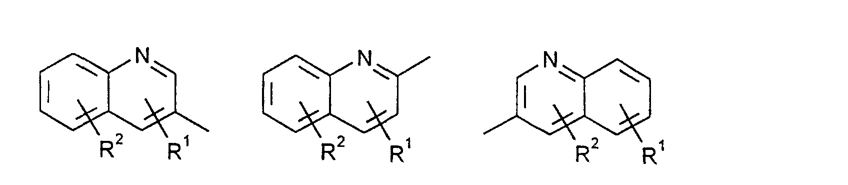 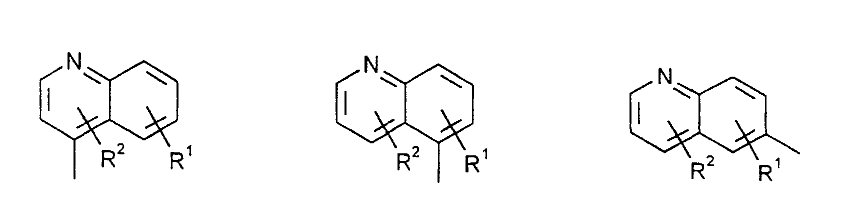 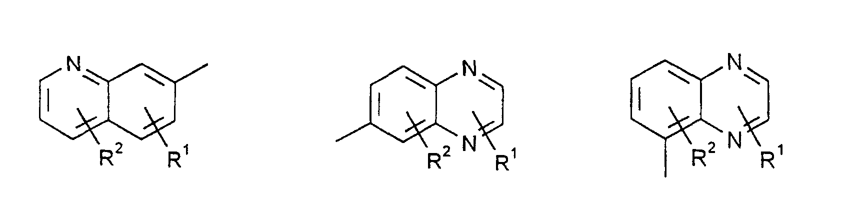 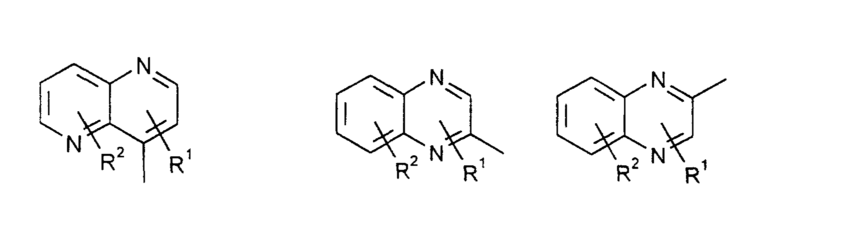 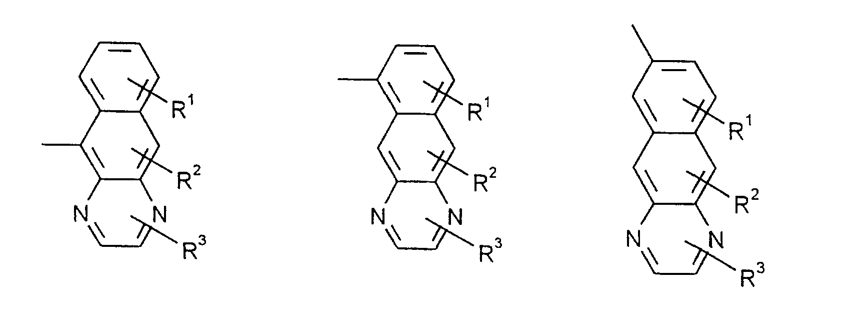 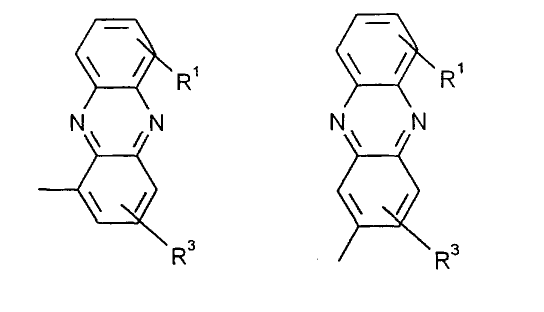 wobei R¹, R² und R³ die oben genannte Bedeutung haben,
steht.

2. Verwendung von Polymeren und/oder Copolymeren gemäß Anspruch 1 als Schicht in elektrolumineszierender Anordnungen.

3. Verwendung von Polymeren und/oder Copolymeren gemäß Anspruch 2 als Elektroneninjektionsschicht, elektronenleitende oder lumineszierende Schicht.

4. Schicht in elektrolumineszierenden Anordnungen, enthaltend Polymere und/oder Copolymere gemäß Anspruch 1.

5. Elektrolumineszierende Anordnung, enthaltend eine Schicht, die Polymere und/oder Copolymere gemäß Anspruch 1 enthält.

## Claims

1. Polymers and/or copolymers with repeating units of the formula (I) 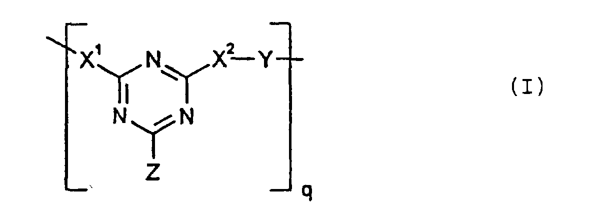 wherein the groups X¹, X², Y and Z can be varied independently,
q is an integer from 3 to 1000,
X¹ and X², independently, represent -O-, -NH-, phenyl or a chemical bond and
Y represents a 2-valent group selected from 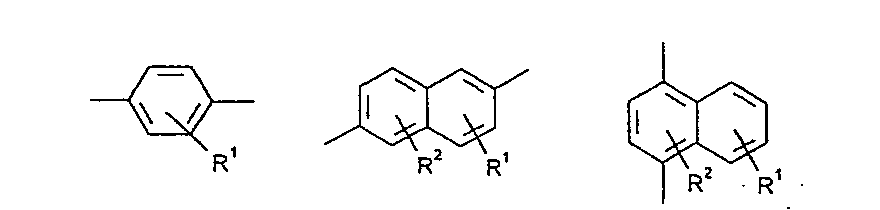 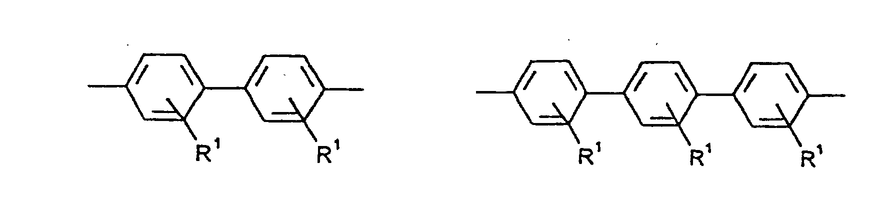 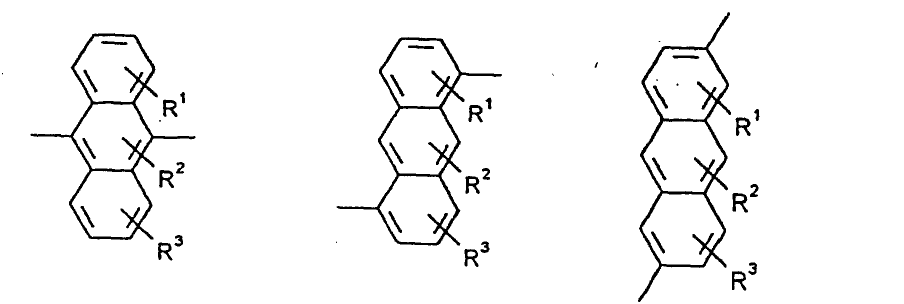 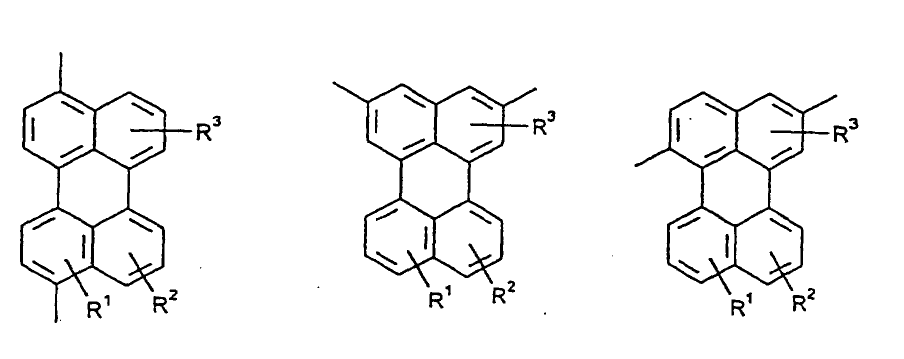 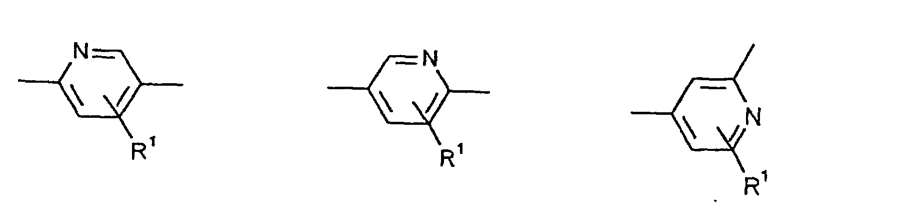 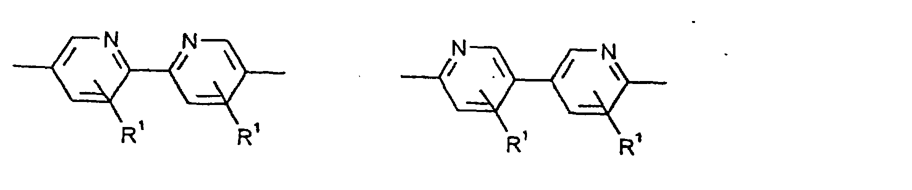 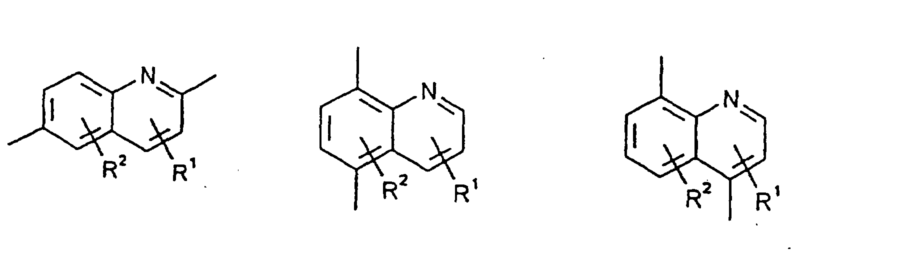 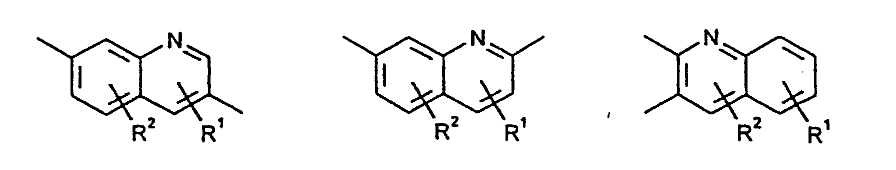 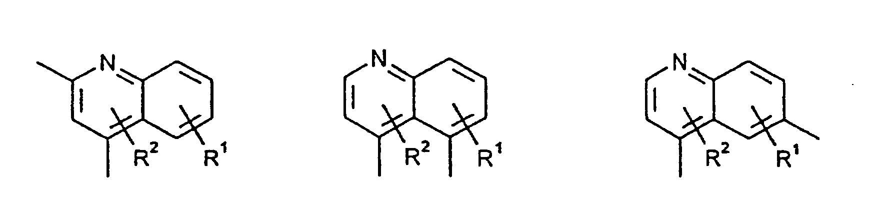 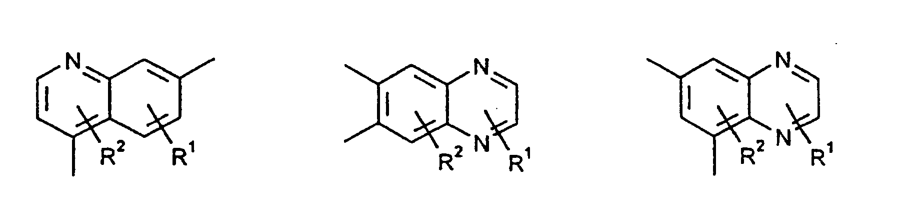 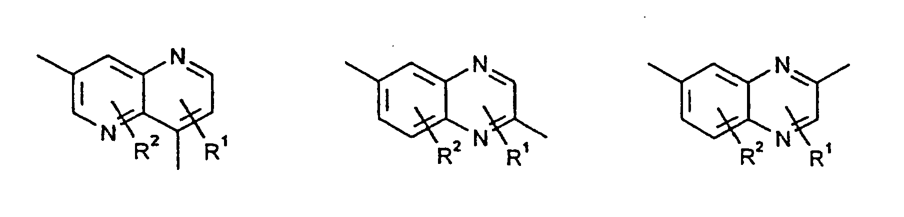 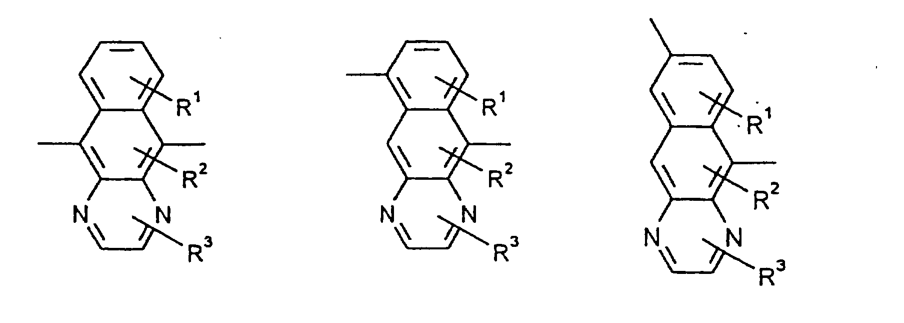 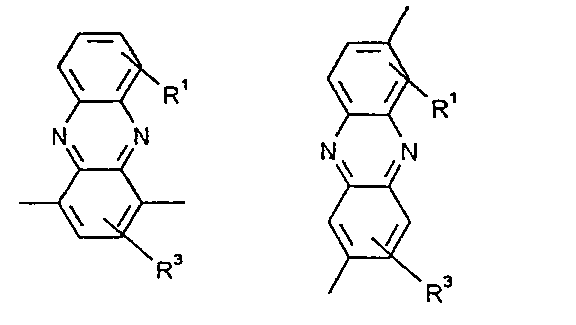 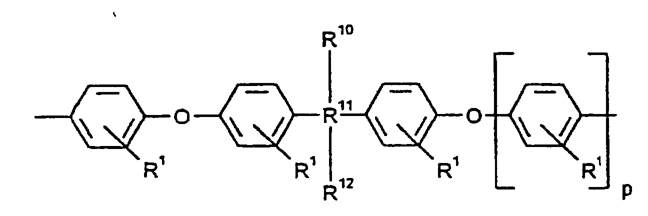 where p = 0 or 1 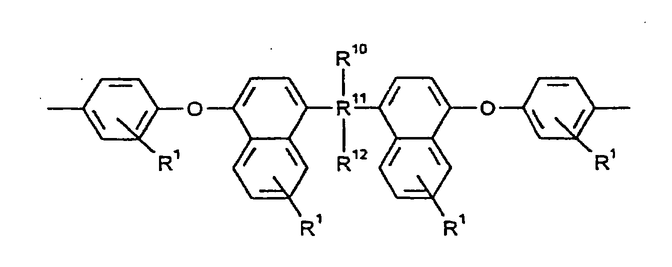 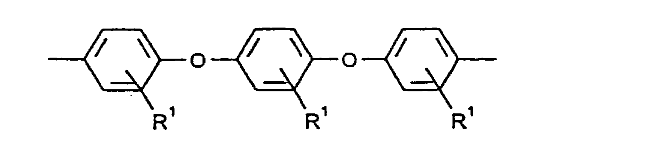 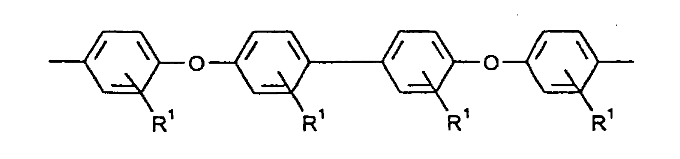 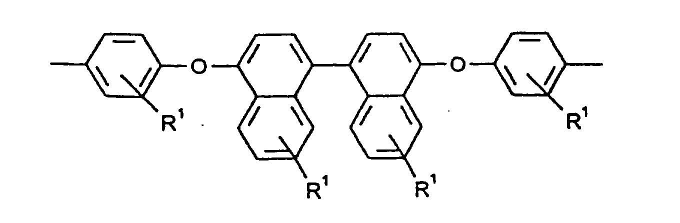 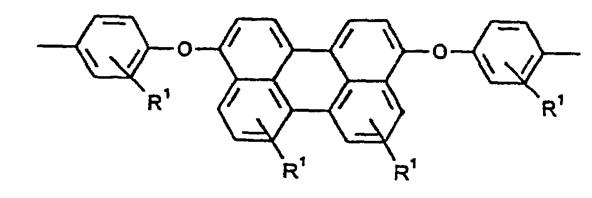 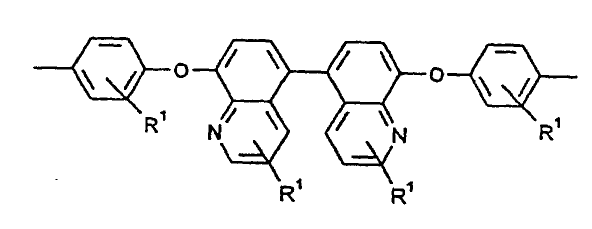 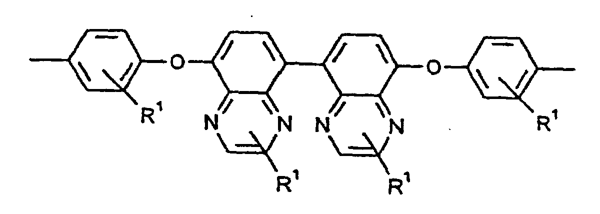 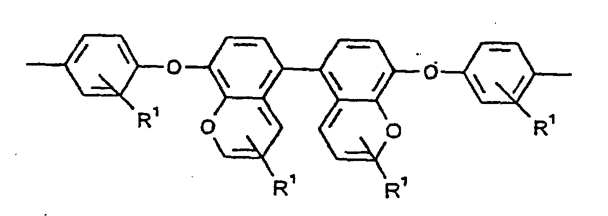 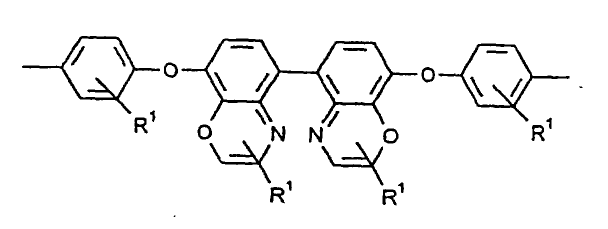 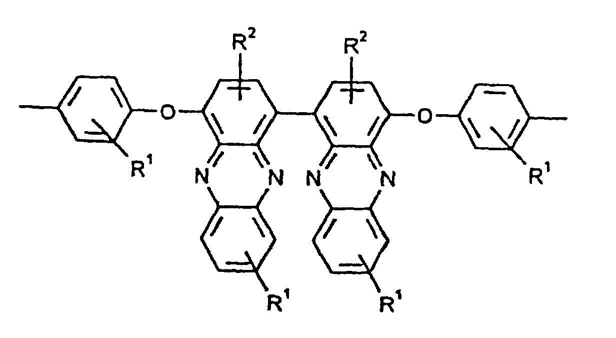 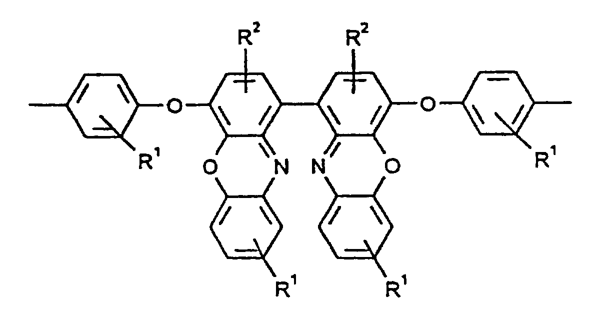 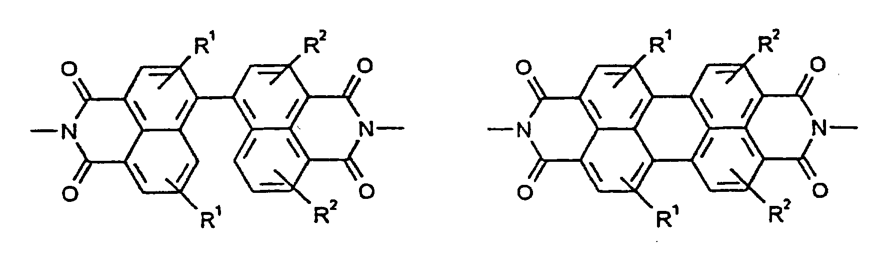 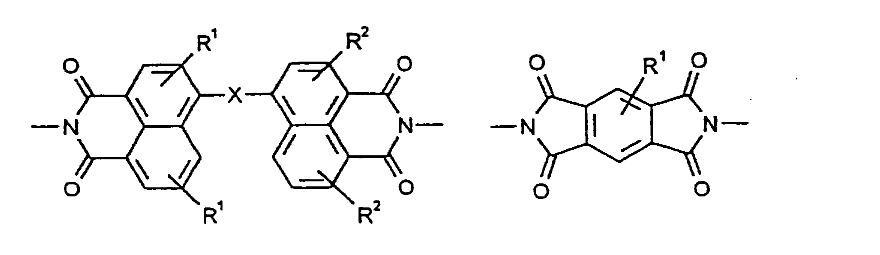 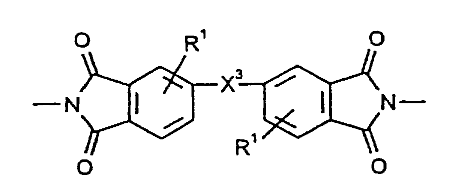 wherein X³ represents 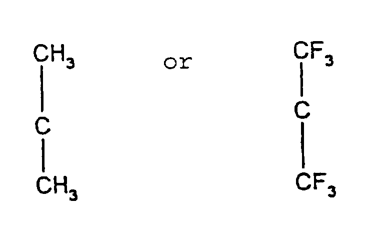 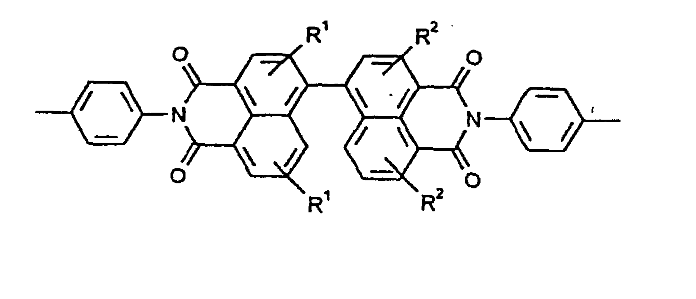 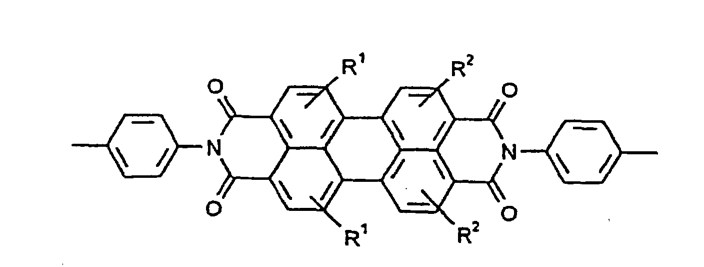 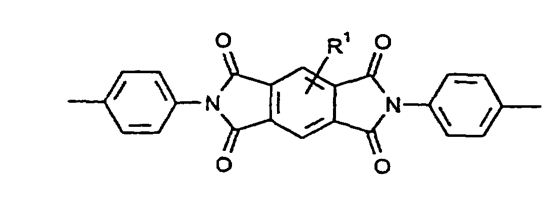
wherein
R¹, R², R³, R¹⁰ and R¹², independently, represent hydrogen, an optionally substituted C₁-C₁₀-alkyl, C₁-C₁₀-alkoxy, alkoxycarbonyl-substituted C₁-C₁₀-alkyl group or, each optionally substituted, an aryl, aryl-C₁-C₆-alkyl or cycloalkyl group
R¹¹ represents the same groups as R¹⁰ or R¹², with the exception of hydrogen, wherein R¹¹ may also represent sulfonyl or sulfoxyl, or
Y represents a group of the formula (II) 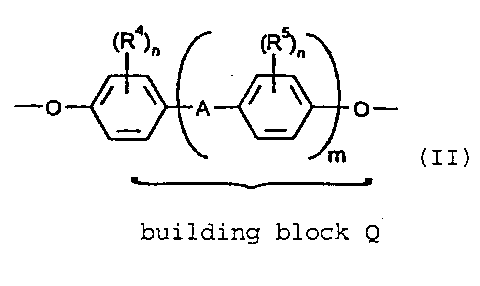
wherein
R⁴ and R⁵ are identical or different and represent halogen, a C₁-C₄-alkyl, C₆-C₁₂-aryl or C₇-C₁₂-aralkyl group,
n is 0 or an integer from 1 to 4,
A represents a chemical bond, CO, O, S, SO₂ or a group of the formula (III) or (IV) 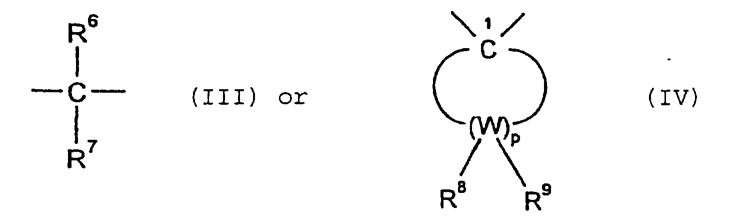
in which
R⁶ and R⁷ are identical or different and represent hydrogen, halogen, a C₁-C₄- alkyl, halogen-C₁-C₄-alkyl, or C₅-C₁₂-cycloalkyl group, optionally with one or more alkyl substituents,
p is an integer from 4 to 7,
R⁸ and R⁹ may be individually selected for each W and, independently, represent hydrogen or C₁-C₆-alkyl, and
W represents carbon,
with the proviso that the groups R⁸ and R⁹ are simultaneously alkyl groups on at least one atom W,
m is 0 or an integer from 1 to 3,
Z represents hydrogen, halogen, CN, an optionally halogen-substituted C₁-C₂₀-alkyl, C₁-C₁₀-alkoxycarbonyl-substituted C₁-C₁₀-alkyl, or, each optionally substituted by halogen, C₁-C₆-alkyl, halogen-C₁-C₆-alkyl and/or C₁-C₆-alkoxy-substituted C₆-C₁₀-aryl, aryl-C₁-C₆-alkyl, pyridyl or isoquinolyl, a C₄-C₁₀-cycloalkyl group or a group of the formula 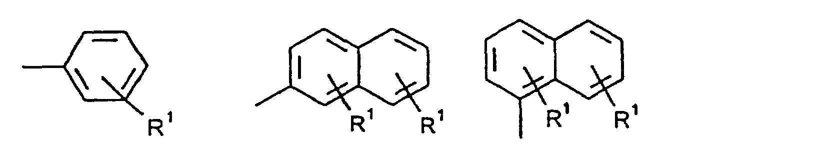 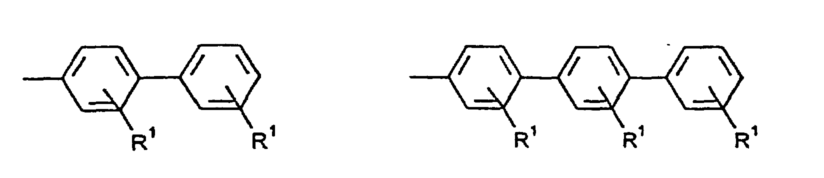 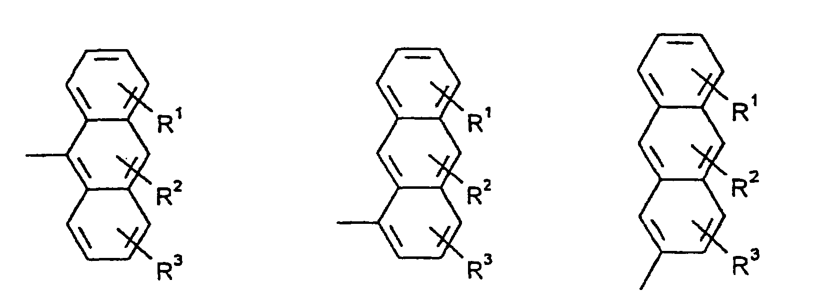 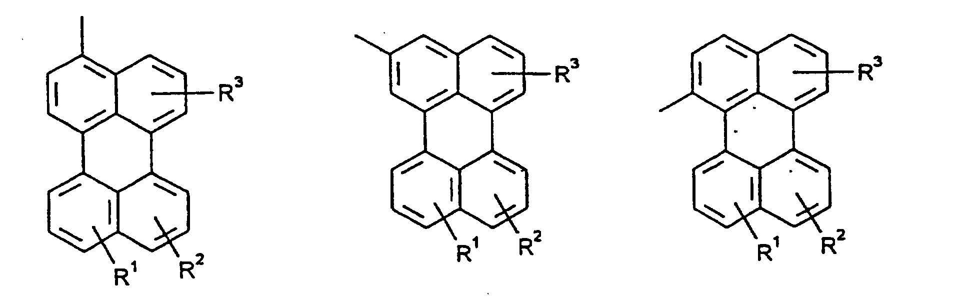 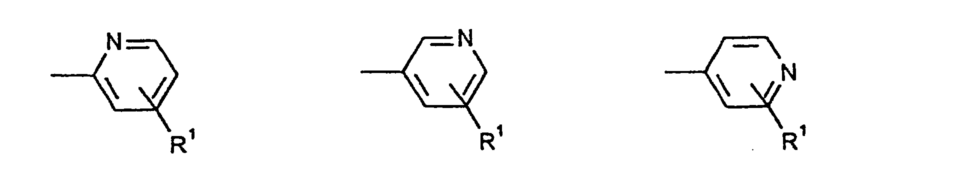 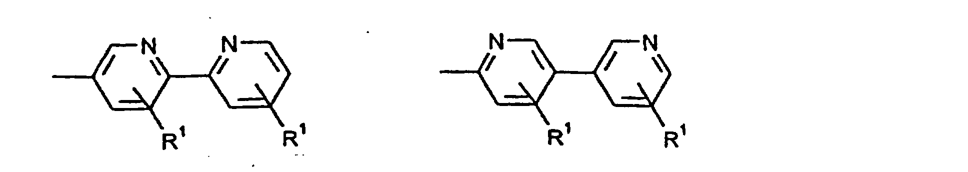 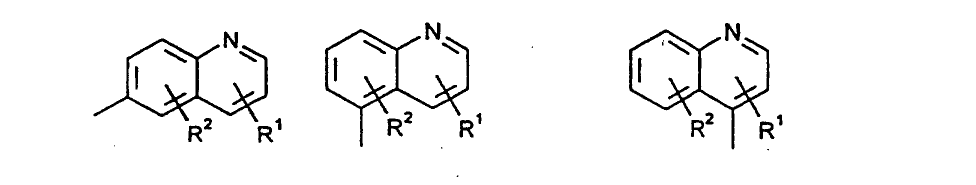 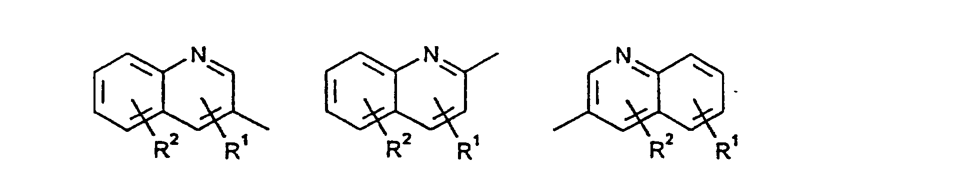 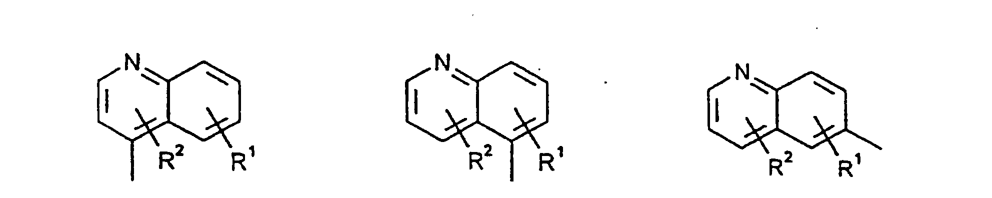 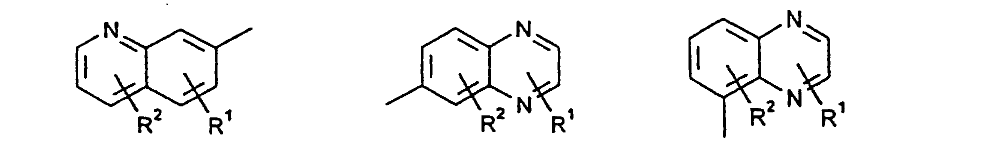 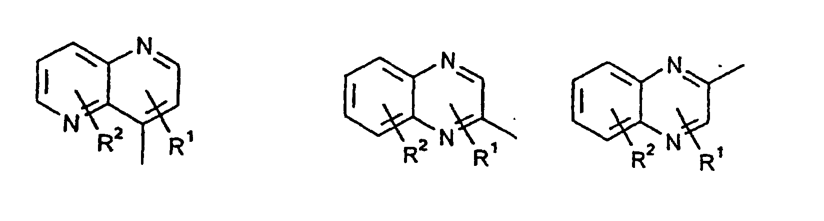 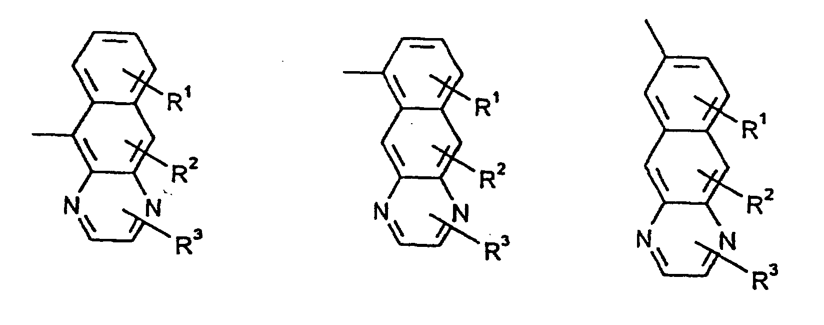 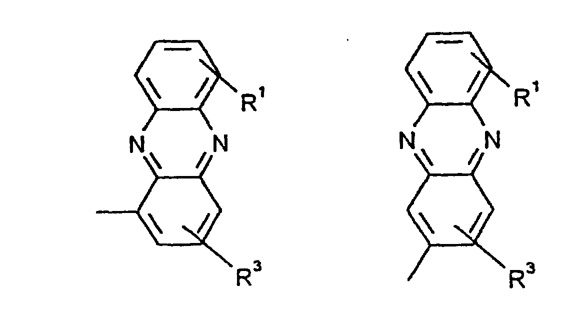 wherein R¹, R² and R³ are defined in the same way as given above.

2. Use of polymers and/or copolymers in accordance with Claim 1 as a layer in electroluminescent arrangements.

3. Use of polymers and/or copolymers in accordance with Claim 2 as an electron injection layer, electron-conducting or luminescent layer.

4. A layer in electroluminescent arrangements containing polymers and/or copolymers in accordance with Claim 1.

5. An electroluminescent arrangement containing a layer which contains polymers and/or copolymers in accordance with Claim 1.

## Revendications

1. Polymères et/ou copolymères comprenant des unités de structure répondant à la formule (I) 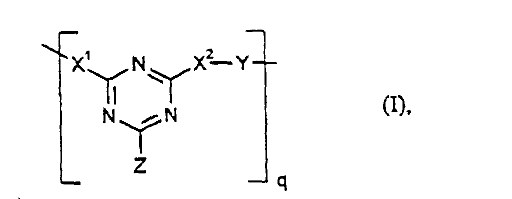 dans laquelle
les radicaux X¹, X², Y, Z peuvent varier indépendamment les uns des autres,
q représente un nombre entier de 3 à 1.000,
X¹ et X² représentent, indépendamment l'un de l'autre, un atome d'oxygène, un groupe -NH-, un groupe phényle ou une liaison chimique, et
Y représente un radical à 2 liaisons choisi parmi le groupe comprenant 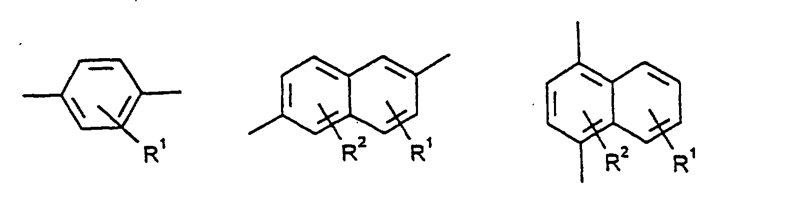 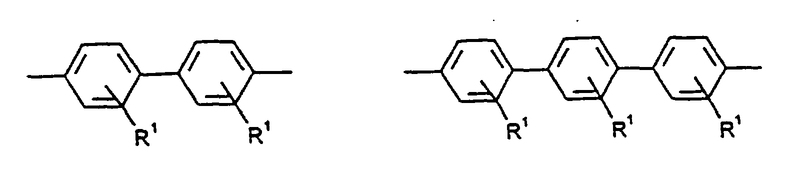 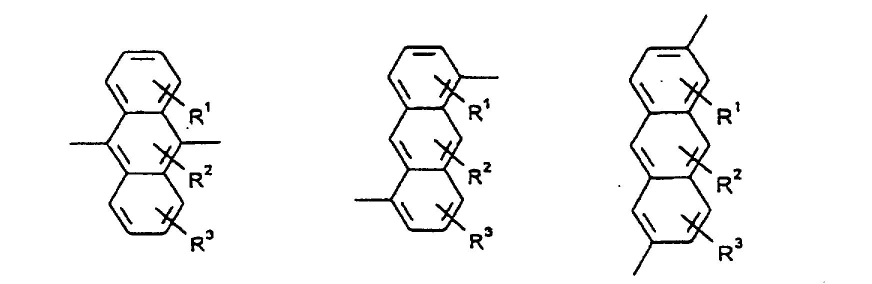 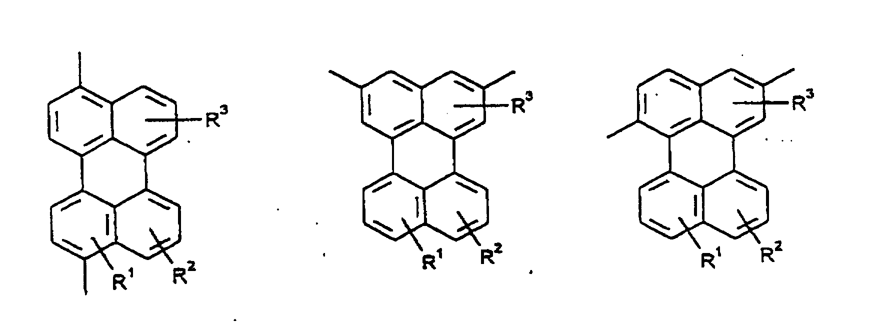 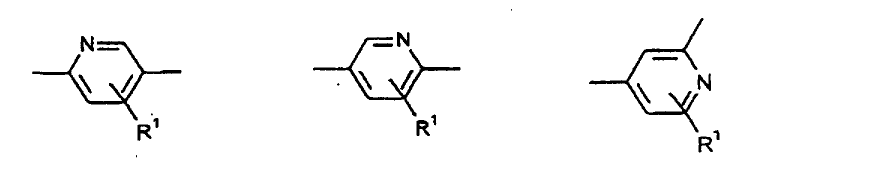 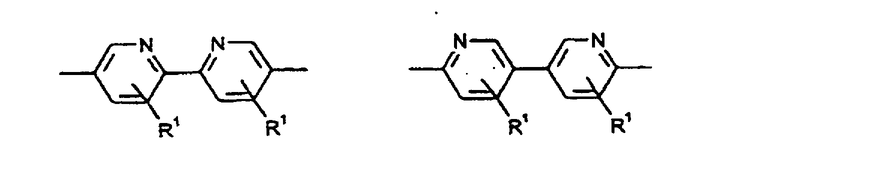 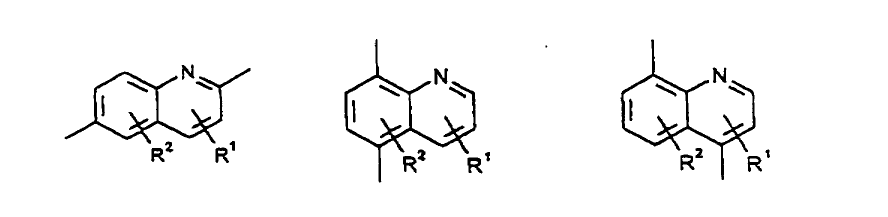 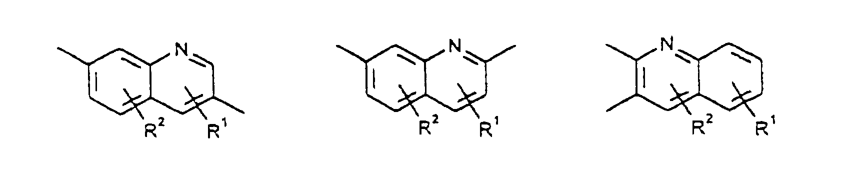 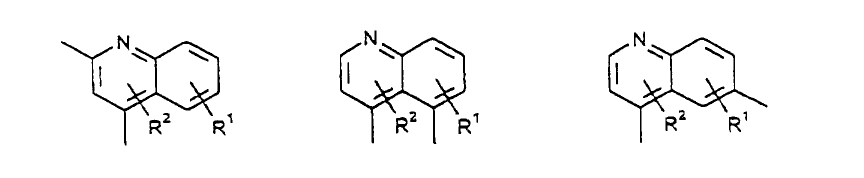 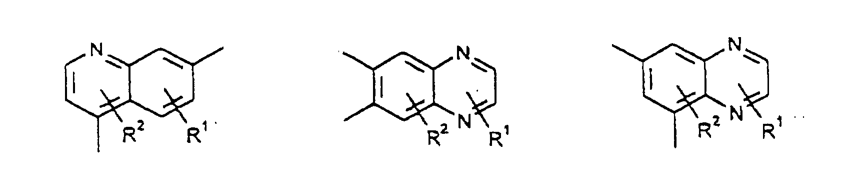 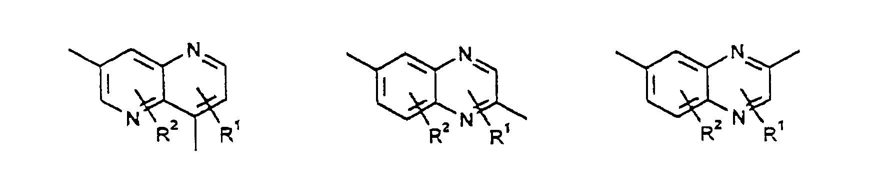 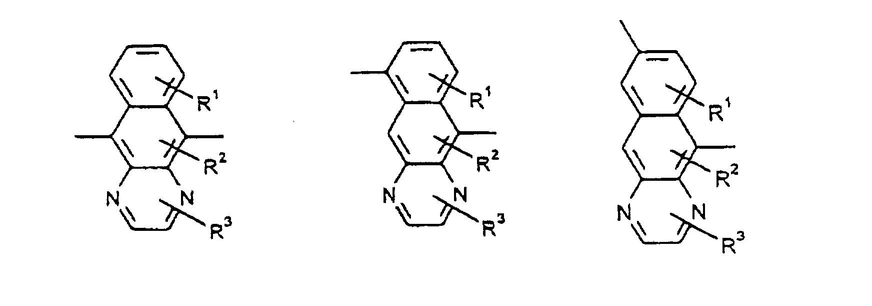 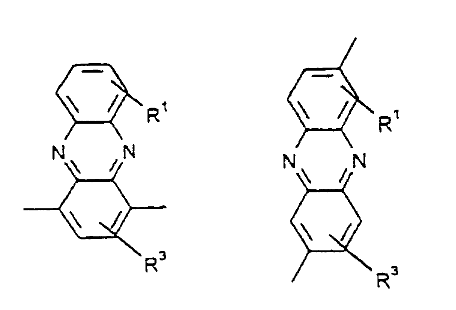 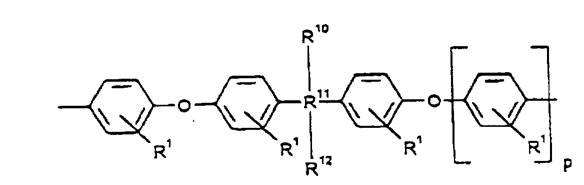 avec p = 0 ou 1 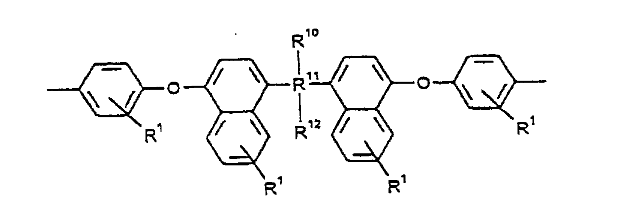 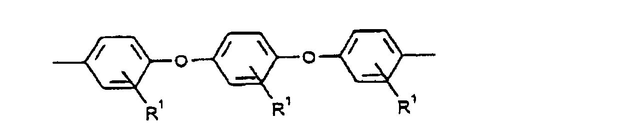 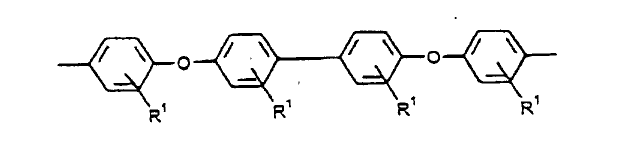 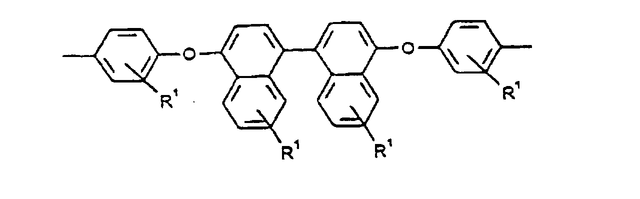 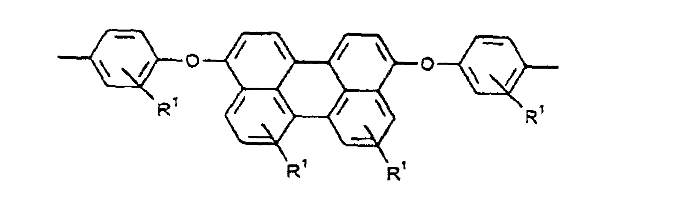 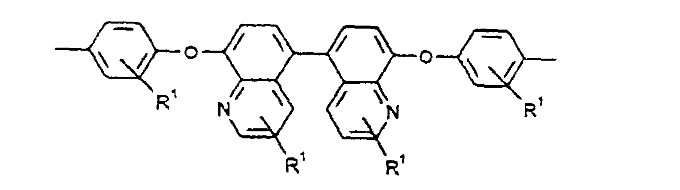 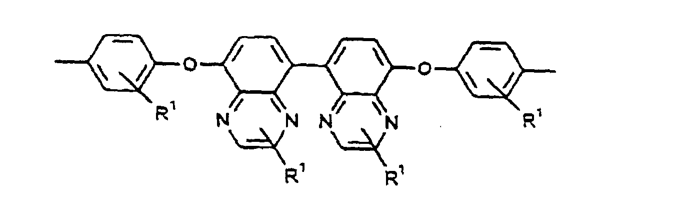 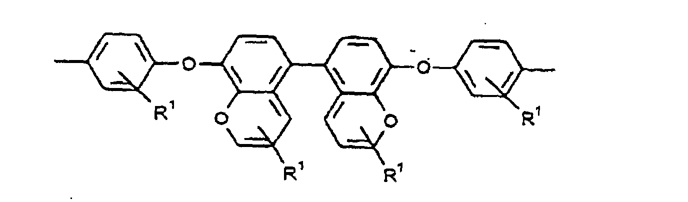 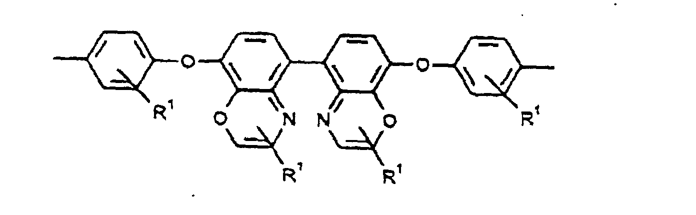 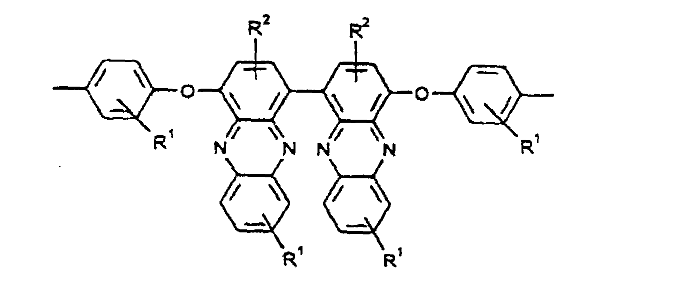 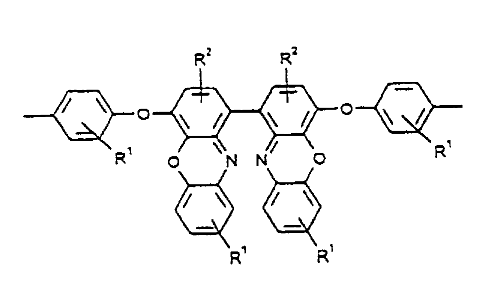 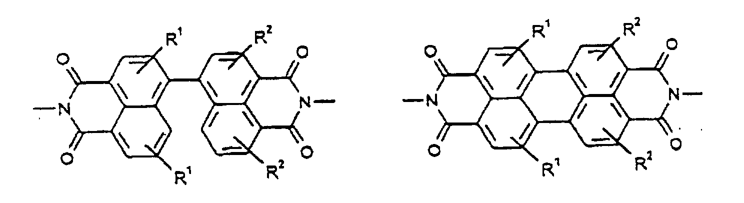 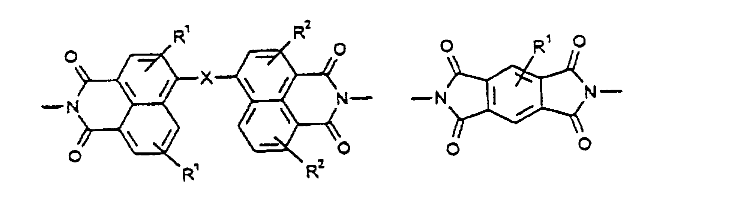 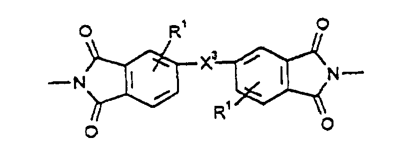
où X³ représente 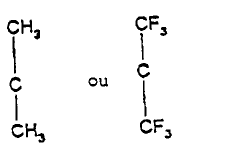 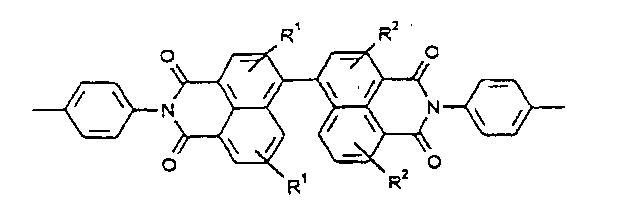 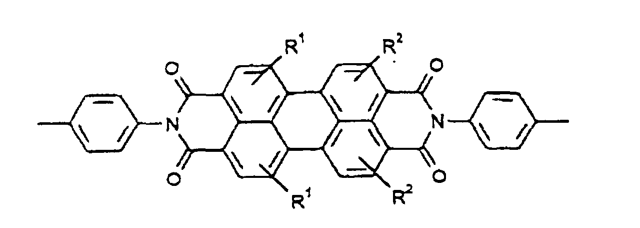 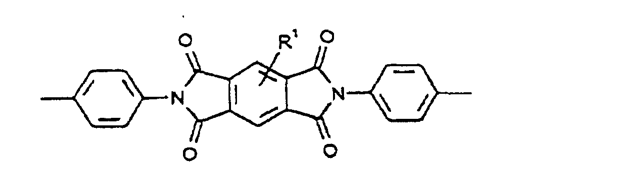
dans lesquels
R¹, R², R³, R¹⁰ et R¹² représentent, indépendamment l'un de l'autre, un atome d'hydrogène, un groupe alkyle en C₁-C₁₀, le cas échéant substitué, un groupe alcoxy en C₁-C₁₀, un groupe alkyle en C₁-C₁₀ portant un ou plusieurs substituants alcoxycarbonyle; un groupe aryle, un groupe arylalkyle en C₁-C₆ ou un groupe cycloalkyle, chacun de ces groupes étant le cas échéant substitué;
R¹¹ représente les mêmes radicaux que R¹⁰ ou R¹² à l'exception d'un atome d'hydrogène, R¹¹ pouvant représenter en outre un groupe sulfonyle ou un groupe sulfoxy, ou bien
Y représente un radical répondant à la formule (II) 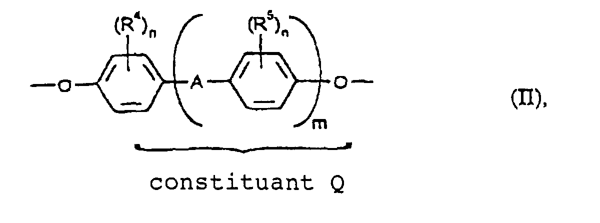
dans laquelle
R⁴ et R⁵ sont identiques ou différents et représentent un atome d'halogène, un groupe alkyle en C₁-C₄, un groupe aryle en C₆-C₁₂ ou un groupe aralkyle en C₇-C₁₂,
n représente 0 ou un nombre entier de 1 à 4,
A représente une liaison chimique, un groupe CO, un atome d'oxygène, un atome de soufre, un groupe SO₂ ou encore un radical répondant à la formule (III) ou (IV) 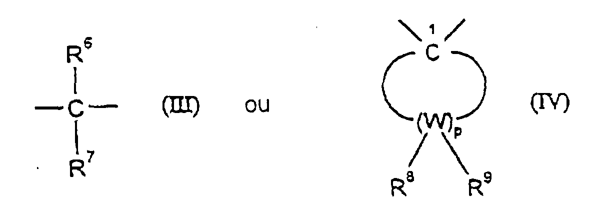 dans laquelle
R⁶ et R⁷ sont identiques ou différents et représentent un atome d'hydrogène, un atome d'halogène, un groupe alkyle en C₁-C₄, un groupe halogénalkyle en C₁-C₄ ou un groupe cycloalkyle en C₅-C₁₂ avec le cas échéant un ou plusieurs substituants du groupe aryle,
P représente un nombre entier de 4 à 7,
R⁸ et R⁹ peuvent être sélectionnés de manière individuelle pour chaque atome W et représentent indépendamment l'un de l'autre un atome d'hydrogène ou un groupe alkyle en C₁-C₆,
W représente un atome de carbone
avec cette mesure que, sur au moins un atome W, les radicaux R⁸ et R⁹ représentent simultanément un groupe alkyle,
m représente 0 ou un nombre entier de 1 à 3,
z représente un atome d'hydrogène, un atome d'halogène, un groupe CN, un groupe alkyle en C₁-C₂₀ portant le cas échéant un ou plusieurs substituants halogéno, un groupe alkyle en C₁-C₁₀ portant un ou plusieurs substituants alcoxy(én C₁-C₁₀)carbonyle, un groupe aryle en C₆-C₁₀, un groupe aryl (alkyle en C₁-C₆), un groupe pyridyle ou un groupe isoquinolyle, chacun de ces groupes portant le cas échéant un ou plusieurs substituants halogéno, alkyle en C₁-C₆, halogénalkyle en C₁-C₆ et/ou halogénalcoxy en C₁-C₆; un groupe cycloalkyle en C₄-C₁₀ ou encore un radical répondant aux formules 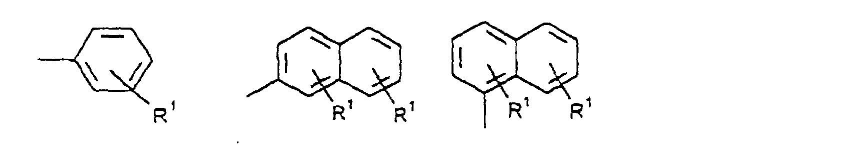 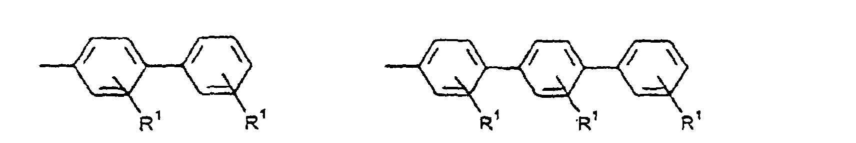 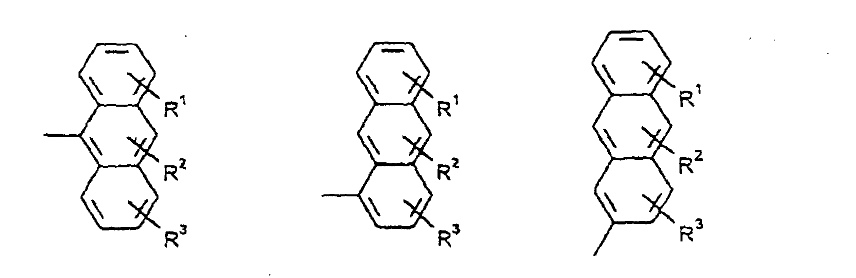 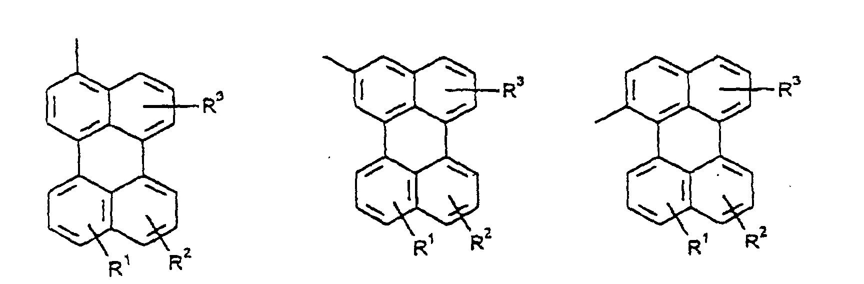 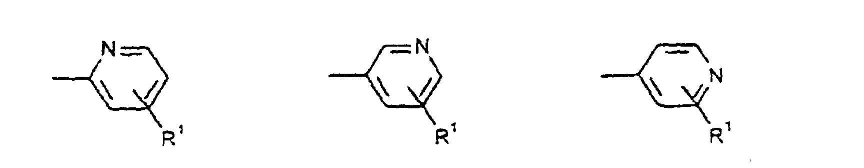 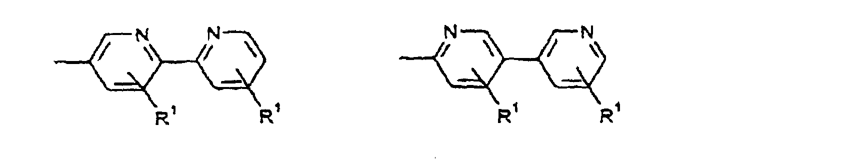 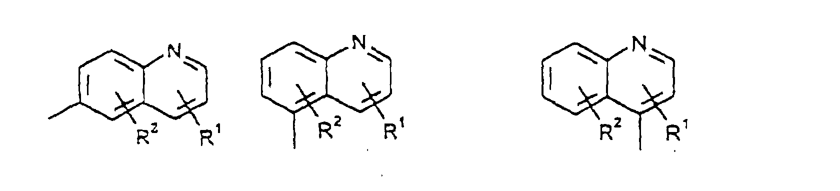 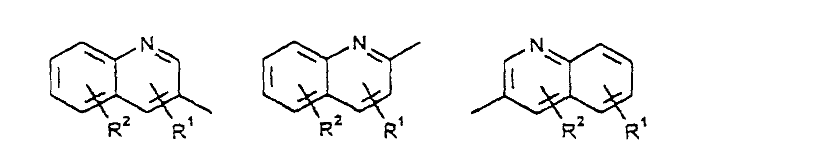 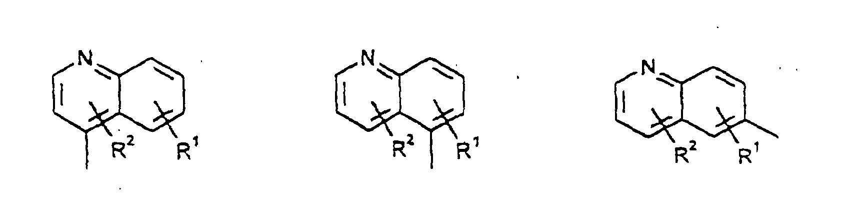 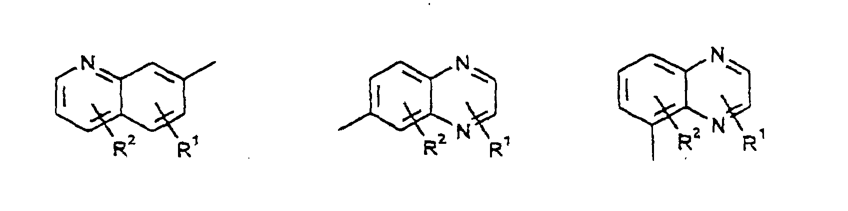 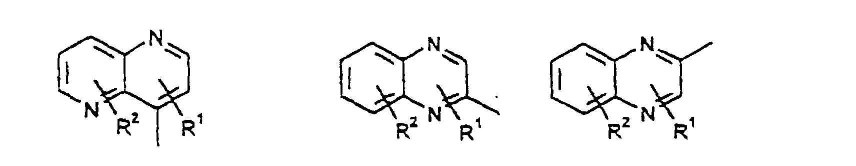 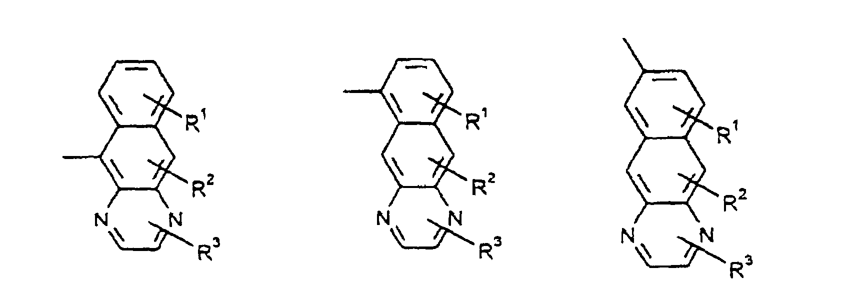 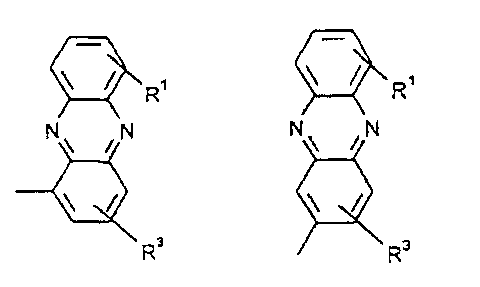 dans lesquelles
R¹, R² et R³ ont la signification indiquée ci-dessus.

2. Utilisation de polymères et/ou de copolymères selon la revendication 1, sous forme de couche dans des agencements électroluminescents.

3. Utilisation de polymères et/ou de copolymères selon la revendication 2, sous forme de couche d'injection d'électrons, de couche conductrice d'électrons ou de couche luminescente.

4. Couche dans des agencements électroluminescents, contenant des polymères et/ou des copolymères selon la revendication 1.

5. Agencement électroluminescent contenant une couche qui contient des polymères et/ou des copolymères selon la revendication 1.
